# EUROPEAN PATENT SPECIFICATION

(11) **EP 3 857 662 B1**
(45) Date of publication and mention of the grant of the patent: **01.07.2026**
(21) Application number: 19869963.9
(22) Date of filing: 01.10.2019
(51) Int. Cl.: H02H 3/16, H01H 89/00, H02H 1/06, H02H 5/04, H02H 5/08, H03K 17/687, H02H 3/24, H02H 3/08

(54) **SOLID-STATE CIRCUIT INTERRUPTERS**
FESTKÖRPER-SCHUTZSCHALTER
INTERRUPTEURS DE CIRCUIT À SEMI-CONDUCTEURS

(30) Priority: 01.10.2018 US 201816149094
(43) Date of publication of application: 04.08.2021
(73) Proprietor: Intelesol, LLC, Danville, CA 94560 (US)
(72) Inventor: TELEFUS, Mark, Orinda, CA 94563 (US)
(74) Representative: Page White Farrer
(86) International application number: PCT/US2019/054102
(87) International publication number: WO 2020/072516

(56) References cited:
- EP-A1- 0 016 646
- WO-A1-2016/105505
- WO-A1-2020/014161
- CA-A1- 3 022 065
- DE-A1- 19 712 261
- GB-A- 1 302 357
- US-A- 5 559 656
- US-A- 6 160 689
- US-A1- 2017 179 946
- US-B2- 7 643 256
- US-B2- 8 482 885

## Description

### Technical Field

This disclosure relates generally to power control systems and devices and, in particular, solid-state circuit interrupter devices and systems for disrupting power loads under fault conditions or hazardous conditions.

### Background

Electrical circuit interrupters are an essential component in electrical distribution systems and are often positioned between an incoming high-current utility supply circuit and lower current branch circuits within a given building or home structure to protect branch circuit conductors and electrical loads from being exposed to over-current conditions. There are several types of over current conditions including overload conditions and fault conditions. An overload condition is defined as operation of equipment in excess of its normal, full-load rating, or a branch circuit in excess of its ampacity which, when the overload persists for a sufficient period of time, would cause damage or dangerous overheating. Fault conditions comprise unintended or accidental load conditions that typically produce much higher over-current conditions than do overloads, depending on the impedance of the fault. A fault producing the maximum over-current condition is referred to as a short-circuit or a "bolted fault."

Conventional circuit interrupters are electromechanical in nature and have electrical contacts that are physically separated by either manual intervention of an operator lever or automatically upon the occurrence of a fault condition or prolonged over current condition, in which cases the circuit interrupter is deemed to be "tripped." The separation of the electrical contacts of a circuit breaker can be performed electromagnetically or mechanically, or a combination of both.

A significant problem with conventional circuit interrupters is that they are slow to react to fault conditions due to their electromechanical construction. Conventional circuit interrupters typically require at least several milliseconds to isolate a fault condition. The slow reaction time is undesirable since it raises the risk of hazardous fire, damage to electrical equipment, and arc-flashes, which can occur at the short-circuit location when a bolted fault is not isolated quickly enough. An arc-flash is an electrical explosion of the electrical conductors that create the short-circuit condition. The energy release in arc-flash can produce temperatures exceeding 35,000°F at the terminals, resulting in rapidly vaporizing metal conductors, blasting molten metal, as well as expanding plasma that is ejected outwards with extreme force. Therefore, arc-flashes are extremely hazardous to life, property and electrical equipment, particularly in industrial and residential applications where the risk of a gas leak is significant.

In addition to being slow at isolating faults, conventional circuit interrupters exhibit large variations in both the time to trip and the current trip limit in response to a fault or prolonged over-current conditions. This variation is predominately due to the limitations of the electromechanical design of the circuit breaker device and the influence of physical factors such as mounting stresses and temperature variation. The variations in the time to trip and the current trip limit can themselves vary from device to device even when the devices are of the same type, the same rating, and the same manufacturer.

Conventional circuit interrupters provide high isolation capability once they have been tripped. However, their slow reaction times, lack of precision and high degree of variability are all very undesirable characteristics. Not only do the slow reaction times result in inadequate protection against the possibilities of arc flashes, but the high degree of variability and lack of precision make coordination between multiple circuit interrupters in a complex system almost impossible.

As a protection device, a circuit interrupter must be able to isolate a fault from the utility supply circuit even when the fault current greatly exceeds the circuit interrupter trip current rating and, thereby, protect against being an internal single point of failure. The Ampere Interrupting Capacity (AIC) rating of a circuit interrupter indicates the maximum fault current (in amperes) that the circuit interrupter device will safely clear when a fault is applied at the load side of the circuit interrupter device. The AIC rating of a circuit interrupter device denotes the maximum fault current that can be interrupted by the circuit interrupter device without failure of the circuit interrupter device. The AIC rating demands an extremely high level of short-circuit protection and domestic circuit interrupters are often rated at an AIC of 10,000 amperes or more.

DE 19712261 A1 discloses an electronic fuse circuit that controls DC power supplied to a load. The electronic fuse circuit is configured control a solid-state switch by controlling a gate voltage applied to the solid-state switch, wherein the gate voltage is controlled to (i) limit an amount of current flow through the solid-state switch from a DC power source to the load or (ii) turn off the solid-state switch and interrupt current flow to the load in response to a detection of a short circuit.

GB 1302357 A discloses a protective system to selectively control power to a load in response to sensed variations in an environmental parameter such as temperature. GB 1 302 357 discloses a protective system which utilizes a triac to control power to a load. The triac comprises a control terminal which is connected to a half-wave rectifier diode which rectifies an input AC voltage to supply half-wave rectified DC voltage to the control terminal of the triac.

WO 2016/105505 discloses methods and apparatus for controlling power to electronic devices and inhibiting the flow of electrical power to the electronic device when it is detected that the electronic device has been exposed to moisture. In addition, WO 2020/014161 discloses power interruption devices and methods to control AC power supplied to a load.

### Summary

The present invention is concerned with a circuit interrupter according to claim 1.

Embodiments of the disclosure include solid-state circuit interrupter devices and systems for interrupting power from a source to a load. According to the invention, a circuit interrupter comprises a solid-state switch and a mode control circuit. The solid-state switch is serially connected between a line input terminal and a load output terminal of the circuit interrupter, and is configured to be placed in one of (i) a switched-on state to provide an electrical connection in an electrical path between the line input terminal and the load output terminal, and (ii) a switched-off state. The mode control circuit is configured to implement a first control mode and a second control mode to control operation of the circuit interrupter. The first control mode is configured to generate a self-bias turn-on threshold voltage for the solid-state switch during power-up of the circuit interrupter, while maintaining the solid-state switch in the switched-off state until the self-bias turn-on threshold voltage is generated. The second control mode is configured to disrupt the self-bias turn-on threshold voltage and place the solid-state switch into the switched-off state.

Disclosed is also another example of circuit interrupter, which is not part of the invention. According to this example, a circuit interrupter comprises a solid-state switch, an air-gap electromagnetic switch, a switch controller, a zero-crossing sensor, and a current sensor. The solid-state switch and the air-gap electromagnetic switch are connected in series between a line input terminal and a load output terminal of the circuit interrupter. The switch controller is configured to control operation of the solid-state switch and the air-gap electromagnetic switch. The zero-crossing sensor is configured to detect zero crossings of a supply power waveform input to the line input terminal of the circuit interrupter. The current sensor is configured to sense a current flowing in the electrical path between the line input terminal and the load output terminal, and detect a fault condition. In response to detection of a fault condition by the current sensor, the switch controller is configured to generate switch control signals to (i) place the solid-state switch into a switched-off state and (ii) place the air-gap electromagnetic switch into a switched-open state after the solid-state switch is placed into the switched-off state. The switch controller utilizes zero-crossing detection signals output from the zero-crossing sensor to detect a zero-crossing event of the supply power waveform and place the air-gap electromagnetic switch into the switched-open state in response to the detected zero-crossing event.

Other embodiments will be described in the following detailed description of embodiments, which is to be read in conjunction with the accompanying figures.

### Brief Description of the Drawings

FIG. 1A schematically illustrates a conventional example of a circuit interrupter.
FIG. 1B schematically illustrates another conventional example of a circuit interrupter.
FIG. 1C schematically illustrates another conventional example of a circuit interrupter.
FIG. 2 schematically illustrates a solid-state circuit interrupter according to an embodiment of the invention.
FIG. 3 schematically illustrates a solid-state circuit interrupter according to another embodiment of the invention.
FIG. 4 schematically illustrates a solid-state circuit interrupter according to another embodiment of the invention.
FIG. 5 schematically illustrates a solid-state circuit interrupter according to another embodiment of the invention.
FIG. 6 schematically illustrates a solid-state circuit interrupter according to another embodiment of the invention.
FIG. 7 schematically illustrates a solid-state circuit interrupter according to another embodiment of the invention.
FIG. 8 schematically illustrates a solid-state circuit interrupter according to an example, which is not part of the invention.
FIG. 9A illustrates a power supply voltage waveform that is input to a line side of the solid-state circuit interrupter of FIG. 8.
FIG. 9B illustrates an output voltage waveform on a load side of the solid-state circuit interrupter of FIG. 8 when a solid-state switch of the circuit interrupter is in a switched-off state and an air-gap electromagnetic switch of the circuit interrupter is in a switched-closed state.
FIG. 10 is a flow diagram of a switch control process which is implemented by a switch controller of the solid-state circuit interrupter of FIG. 8.
FIG. 11A is a schematic block diagram of an AC-to-DC converter circuit which can implemented in the solid-state circuit interrupter of FIG. 8.
FIG. 11B is a schematic circuit diagram of the AC-to-DC converter circuit of FIG. 11A, according to an example, which is not part of the invention.

### Detailed Description of Exemplary Embodiments

Embodiments of the disclosure will now be described in further detail with regard to solid-state circuit interrupter devices and systems for interrupting power from a source to a load based on the detection of fault conditions (e.g., short-circuit faults, over-current faults, ground faults, arc faults, etc.) and the detection of hazardous environmental conditions (e.g., flooding, chemical spills, gas leaks, etc.). It is to be understood that same or similar reference numbers are used throughout the drawings to denote the same or similar features, elements, or structures, and thus, a detailed explanation of the same or similar features, elements, or structures will not be repeated for each of the drawings. In addition, the terms "about" or "substantially" as used herein with regard to percentages, ranges, etc., are meant to denote being close or approximate to, but not exactly. For example, the term "about" or "substantially" as used herein implies that a small margin of error is present, such as 1% or less than the stated amount. The term "exemplary" as used herein means "serving as an example, instance, or illustration". Any embodiment or design described herein as "exemplary" is not to be construed as preferred or advantageous over other embodiments or designs.

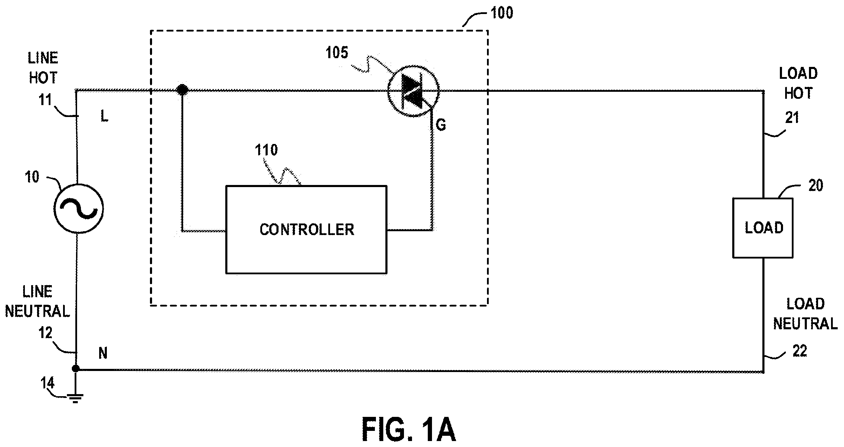

FIG. 1A schematically illustrates a conventional example of a circuit interrupter. In particular, FIG. 1A illustrates a circuit interrupter 100 connected between a utility power supply 10 (referred to herein as AC mains 10) and a load 20 which is connected to a branch circuit that is protected by the circuit interrupter 100. As further illustrated in FIG. 1A, the circuit interrupter 100 is connected between a hot phase 11 (referred to as "line hot") of the AC mains 10 and a load hot line 21 of the load 20, while a neutral phase 12 (referred to as "line neutral") of the AC mains 10 is directly connected to a load neutral line 22 of the load 20. As further illustrated in FIG. 1A, the line neutral 12 is shown bonded to earth ground 14 (GND), which provides added protections as is known in the art.

The circuit interrupter 100 comprises an AC switch 105 and a controller 110. The AC switch 105 comprises a TRIAC or a silicon controlled rectifier (SCR). The TRIAC switch 105 is a three terminal electronic device that conducts current in both directions under control of the controller 110. The TRIAC is often found in conventional wall-mounted dimming switches. The controller 110 is representative of many possible control embodiments whether they be logic gates, a microcontroller, or an electromechanical control such as the bi-metal bending strips utilized in conventional circuit breakers. The controller 110 can apply a control signal to a gate (G) of the TRIAC switch 105 for phase angle modulation and to turn the TRIAC switch 105 on and off. The phase angle control of the TRIAC switch 105 allows control of the average current flowing into the load 20, and is commonly used for controlling the speed of a motor, dimming lights, or controlling electric heaters, etc.

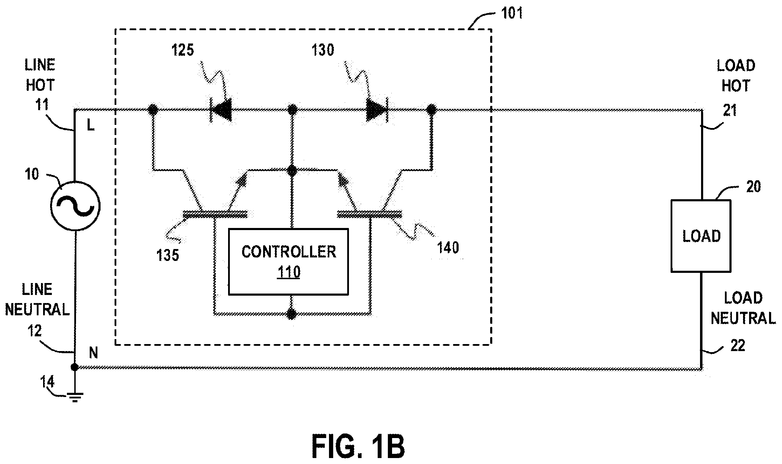

FIG. 1B schematically illustrates another conventional example of a circuit interrupter 101. The circuit interrupter 101 comprises a controller 110 and an AC switch which comprises a first diode 125, a second diode 130, a first transistor 135, and a second transistor 140, which are interconnected as shown in FIG. 1B. The first and second transistors 135 and 140 comprise insulated-gate bipolar transistor (IGBT) devices. The controller 110 controls current flow by injecting a control signal simultaneously into the first and second transistors 135 and 140. In the AC switch configuration shown in FIG. 1B, current only flows through first switch 135 and the second diode 130 in a positive half-cycle of a supply voltage waveform of the AC mains 10, while current only flows through the second switch 140 and the first diode 125 during negative half-cycles of the supply voltage waveform of the AC mains 10.

A disadvantage of the circuit interrupter 101 shown in FIG. 1B is that it requires the implementation of four discrete elements (e.g. diodes 125 and 130 and BJT devices 135 and 140). In addition, the BJT devices 135 and 140 do not efficiently operate as bidirectional switches, and the discrete diodes 125 and 130 must be utilized for bidirectional switching. In addition, the discrete diodes 125 and 130 have relatively large forward bias voltage drops of about 0.7 V, as compared to the forward bias voltage drop of about 0.1 V-0.2 V of the BJT devices 135 and 140. As such, the diodes 125 and 130 increase the power dissipation of the circuit interrupter 101.

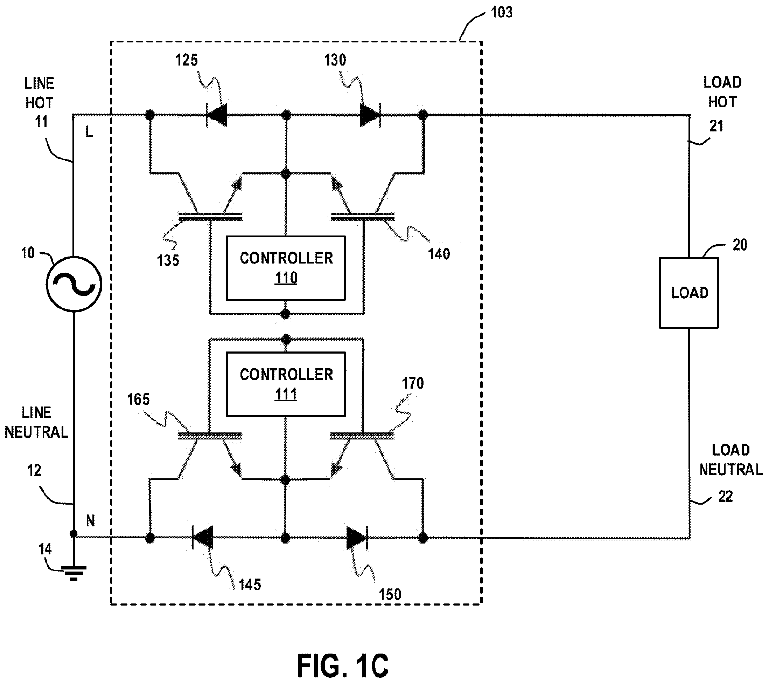

FIG. 1C schematically illustrates another conventional example of a circuit interrupter 103. The circuit interrupter 103 is similar to the circuit interrupter 101 of FIG. 1B in that the circuit interrupter 103 comprises a first controller 110 and a first AC switch which comprises a first diode 125, a second diode 130, a first transistor 135, and a second transistor 140, which are interconnected as shown in FIG. 1C to provide bidirectional switching in the electrical path between the line hot 11 and the load hot 21. The circuit interrupter 103 further comprises a second controller 111 and a second AC switch which comprises a first diode 145, a second diode 150, a first transistor 165, and a second transistor 170, which are interconnected as shown in FIG. 1C to provide bidirectional switching in the electrical path between the line neutral 12 and the load neutral 22.

The transistors 135, 140, 165, and 170 comprise insulated-gate bipolar transistors.

The first controller 110 controls current flow by applying a control signal simultaneously to switches 135 and 140, while the second controller 111 controls current flow by applying a control signal simultaneously to switches 165 and 170. During positive half cycles of the AC supply voltage waveform of the AC mains 10, current flows (i) in the hot line path through the switch 135 and the diode 130 and (ii) in the neutral line path through the switch 170 and the diode 145. On the other hand, during negative half cycles of the AC supply voltage waveform of the AC mains 10, current flows (i) in hot line path through the switch 140 and the diode 125 and (ii) in the neutral line path through the switch 165 and the diode 150. This configuration of simultaneously controlling AC switches on both line and neutral is referred to as double-pole switching and may be applied to two lines of differing phase from a single AC energy source. Double pole switching of line and neutral is a common AC switching technique in the life saving applications of ground-fault circuit interrupters. The circuit interrupter 103 has similar disadvantages as the circuit interrupter 102 discussed above, but enhanced by the fact that the circuit interrupter includes 4 additional discrete components with the additional diodes 145 and 150 increasing power dissipation.

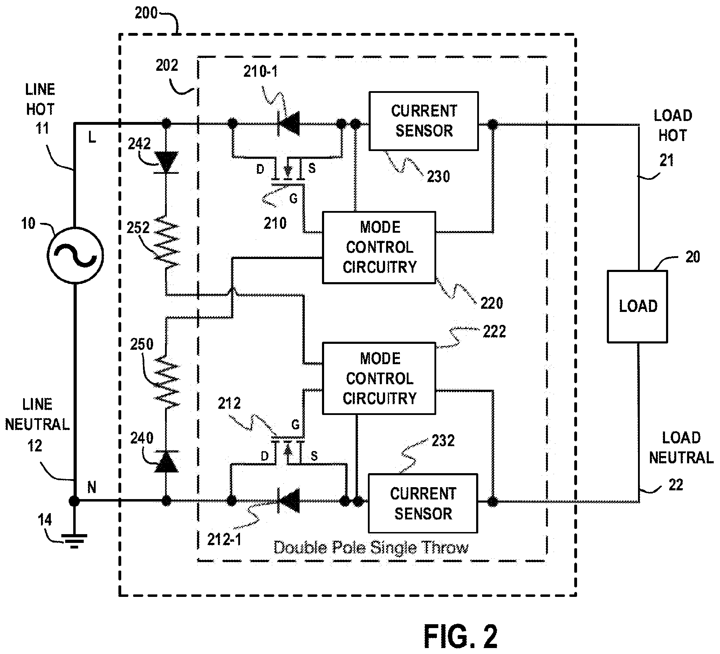

Exemplary embodiments of the invention as shown in FIGs. 2, 3, 4, 5, 6, and 7 include novel architectures for circuit interrupter devices and systems that can be positioned between an input energy source and an output load. While the exemplary circuit interrupters are generically depicted as connecting an AC mains 10 and load 20, it is to be understood that the exemplary circuit interrupters can be embodied in various devices and applications. For example, in some embodiments, the circuit interrupters shown in FIGs. 2-7 can be implemented in an electrical circuit breaker device (e.g., intelligent circuit breaker device), which is disposed in a circuit breaker distribution panel. In addition, in some embodiments, the circuit interrupters shown in FIGs. 2-7 can be implemented in an electrical receptacle device, or an electrical light switch (e.g., a wall-mounted light switch or a light switch implemented in a smart light fixture or smart ceiling light bulb socket, etc.). In other embodiments, the circuit interrupters shown in FIGs. 2-7 may comprise standalone devices that can be disposed within a gang box in an electrical network of a home or building and configured to protect one or more electrical devices, appliances, loads, etc. that are connected in a branch circuit downstream of the standalone circuit interrupter device.

FIG. 2 schematically illustrates a solid-state circuit interrupter according to an embodiment of the invention.

In particular, FIG. 2 schematically illustrates a solid-state circuit interrupter 200 connected between an AC mains 10 and a load 20. The solid-state circuit interrupter 200 comprises a double pole single throw (DPST) switch circuit 202 which comprises a first solid-state switch 210, a second solid-state switch 212, a first mode control circuit 220, a second mode control circuit 222, a first current sensor 230, and a second current sensor 232. The solid-state circuit interrupter 200 further comprises a first bias branch circuit comprising a first diode 240 and a first resistor 250, and a second bias branch circuit comprising a second diode 242 and a second resistor 252. The first diode 240 and the first resistor 250 are serially connected between the line neutral 12 and the first mode control circuit 220. The second diode 242 and the second resistor 252 are serially connected between the line hot 11 and the second mode control circuit 222.

In the exemplary embodiment of FIG. 2, the first and second solid-state switch elements 210 and 212 comprises power MOSFET (metal-oxide semiconductor field-effect transistor) devices and, in particular, N-type enhancement MOSFET devices having gate terminals (G), drain terminals (D), and source terminals (S) as shown. In the exemplary embodiment of FIG. 2 (and other embodiments discussed herein), the first and second solid-state switches 210 and 212 comprise respective intrinsic body diodes 210-2 and 212-1, which represent the P-N junctions between a P-type substrate body to N-doped drain regions of the MOSFET devices. In this regard, the body diodes 210-1 and 212-1 are intrinsic elements of the MOSFET switches 210 and 212 (i.e., not discrete elements). It is to be noted that the intrinsic body-to-source diodes of the solid-state switches 210 and 212 are not shown as it is assumed that they are shorted out by connections between the source regions and the substrate bodies (e.g., N+ source and P body junction are shorted through source metallization).

The first and second mode control circuits 220 and 222 are configured to implement multiple control modes for the solid-state interrupter 200 including (i) a self-bias turn-on threshold voltage control mode and (ii) a forced turn-off control mode. In some embodiments, the self-bias turn-on threshold voltage control mode utilizes a self-biasing circuit to generate a target turn-on threshold voltage level for the solid-state switches 210 and 212, while preventing the solid-state switches 210 and 212 from turning on before the target self-bias turn-on threshold voltage level is reached and applied to the solid-state switches 210 and 212 to turn-on the solid-state switches 210 and 212.

As explained in further detail below, a self-bias network is configured to delay the application of a gate voltage to the gate terminals of the solid-state switches 210 and 212 which delay is long enough to prevent premature "turn-on" of the switches 210 and 212 before the self-bias turn-on threshold voltage level is generated. Indeed, the premature turn-on of the solid-state switches 210 and 212 would prevent the generation of the self-bias turn-on threshold voltage to the target voltage level. The self-bias turn-on threshold voltage control mode is supported by the first and second bias branch circuits with an opposite cycle arrangement comprised of the diodes 240 and 242 and the resistors 250 and 252.

In some embodiments, the forced turn-off control mode of the first and second mode control circuits 220 and 222 is configured to force a turn-off of the solid-state switches 210 and 212 in response to the detection of certain events including, but not limited to, detection of fault events, detection of hazardous environmental conditions, remote commands for circuit interruption, etc. As explained in further detail below, the forced turn-off control mode can be initiated on commands by, e.g., direct hardware fault sensing and control, and/or through a galvanically isolated control input based on, but not limited to, optical, magnetic, capacitive, and RF isolation technologies.

In some embodiments, the first and second current sensors 230 and 232 are configured to sense a magnitude of current flowing to and from the load 20 and generate current sense data that is utilized by the first and second mode control circuits 220 and 222 to identify fault events such as short-circuit fault events, over-current fault events, arc fault events, etc. In response to the detection of such fault events, the first and second current sensors 230 and 232 are configured to trigger the force turn-off mode which results in the first and second solid-state switches 210 and 212 being turned-off. The first and second current sensors 230 and 232 may be implemented using various types of sensing techniques and circuits, including, but not limited to, sensing techniques that are based on sense resistors, current transformers, Hall-effect sensors, or the internal impedance (drain-source resistance) of the solid-state switches 210 and 212. The mode control circuits 220 and 222 can be implemented using various types of control architectures based on, e.g., logic gates, microcontrollers, electromechanical control devices, etc.

In normal operation of the solid-state interrupter 200, during positive half-cycles of the supply voltage waveform of the AC mains 10, the first mode control circuit 230 applies the generated self-bias turn-on threshold voltage to the gate terminal of the first solid-state switch 210 to turn on the first solid-state switch 210. In this configuration, the positive current flows from the line hot 11 through the first solid-state switch 210 to the load 20, and current returns to the line neutral 12 through the forward-biased intrinsic diode 212-1 of the second solid-state switch 212. On the other hand, during negative half-cycles of the supply voltage waveform of the AC mains 10, the second mode control circuit 222 applies the generated self-bias turn-on threshold voltage to the gate terminal of the second solid-state switch 212 to turn on the second solid-state switch 212. In this configuration, the negative current flows from the line neutral 12 through the second solid-state switch 212 to the load 20, and current returns to the line hot 11 through the forward-biased intrinsic diode 210-1 of the first solid-state switch 210.

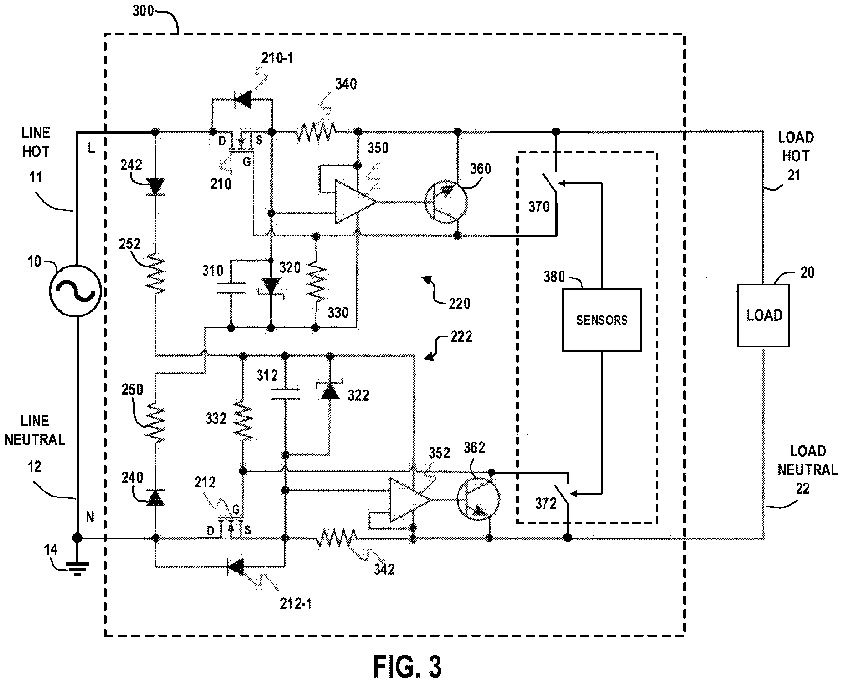

FIG. 3 schematically illustrates a solid-state circuit interrupter according to another embodiment of the invention.

In particular, FIG. 3 schematically illustrates a solid-state circuit interrupter 300 which is based on the framework of FIG. 2, but which further illustrates an exemplary embodiment of the first and second mode control circuits 220 and 222. As shown in FIG. 3, the first mode control circuit 220 comprises a capacitor 310, a Zener diode 320, a resistor 330, an operational amplifier 350 (configured as a comparator), control switches 360 and 370, and sensors 380. Similarly, the second mode control circuit 222 comprises a capacitor 312, a Zener diode 322, a resistor 332, an operational amplifier 352 (configured as a comparator), control switches 362 and 372, and sensors 380. The mode control circuits provide exemplary embodiments for implementing (i) a self-bias turn-on threshold voltage control mode using the circuit components 310/312, 320/322, 330/332, 350/352, and 360/362, and (ii) a forced turn-off control mode using the circuit components 340/342, 370/372, and sensors 380.

For example, for the self-bias turn-on threshold voltage control mode, the comparators 350 and 352 will output a control voltage which is sufficient to activate the control switches 360 and 362 and effectively short the gate-to-source of the first and second solid-state switches 210 and 212. The solid-state switches 210 and 212 are maintained in a switched-off state for a sufficient amount of time to generate the self-bias turn-on threshold voltages for the solid-state switches 210 and 212.

For example, during a positive half cycle of the AC supply voltage waveform of the AC mains 10, current flows from the line hot 11 to the line neutral 12 through the second branch circuit (comprising the diode 242 and the resistor 252), the capacitor 312, and the body diode 212-1. This current flow causes a voltage across the capacitor 312 to increase until the capacitor voltage reaches a target self-bias turn-on threshold voltage level across the capacitor 312 which represents a clamping voltage (i.e., reverse breakdown voltage of the Zener diode 322, referred to as Zener voltage). In other words, the Zener voltage of the Zener diode 322 limits the maximum level of the self-bias turn-on threshold voltage (V_{GS}) which is generated to turn on the second solid-state switch 212.

Next, during a negative half cycle of the AC supply voltage waveform of the AC mains 10, current flows from the line neutral 12 to the line hot 11 through the first branch circuit (comprising the diode 240 and the resistor 250), the capacitor 310, and the body diode 210-1. This current flow causes a voltage across the capacitor 310 to increase until the capacitor voltage reaches target turn-on threshold voltage level across the capacitor 310 which represents a clamping voltage (Zener voltage) of the Zener diode 320. In other words, the Zener voltage of the Zener diode 320 limits the maximum level of the self-bias turn-on threshold voltage (V_{GS}) which is generated to turn on the first solid-state switch 210.

In this exemplary embodiment, the target threshold voltage level for the solid-state switches 210 and 212 is limited by the Zener voltages of the Zener diodes 320 and 322 such that the Zener diodes 320 and 322 serve as a solid-state clamp to limit the turn-on threshold voltage. In this regard, the self-bias turn-on threshold voltage control mode is input-line voltage independent, as the level of the self-bias turn-on threshold voltage is limited by the solid-state clamp.

As noted above, in the exemplary mode control framework of FIG. 3, the solid-state switches 210 and 212 are maintained in a switched-off state for a sufficient period of time to charge the capacitors 310 and 312 to the Zener voltages of the Zener diodes 320 and 322. In some embodiments, the Zener voltage is about 15 V, and the turn-on threshold voltage of the solid-state switches 210 and 212 is in a range of about 10 V to about 15 V. If the solid-state switches 210 and 212 turn on prematurely before reaching the clamping voltage of the Zener diodes 320 and 322 due to, e.g., leakage, Miller capacitance of the MOSFET devices, etc., the solid-state switches 210 and 212 can actually turn on with less than 2 V of gate-to-source voltage, which would prevent the capacitors 310 and 312 from being charged enough to generate a capacitor voltage which corresponds to the clamping voltage of the Zener diodes 320 and 322. In this regard, the self-bias turn-on threshold voltage control mode is configured to maintain the control switches 360 and 362 turned-on for a period of time which is sufficient keep the first and second solid-state switches 210 and 212 turned-off and allow the capacitors 310 and 312 to be charged to the clamping voltages of the Zener diodes 320 and 322.

As noted above, the mode control circuits 220 and 222 implement a forced turn-off control mode using the circuit components 340, 342, 370, 372, and 380. In particular, during operation of the solid-state circuit interrupter 300, the switches 370 and 372 can be activated by one of the sensors 380 to effectively shunt the gate-to-source terminals and turn-off the solid-state switches 210 and 212. The sensors 380 can include one or more of various types of sensors. For example, in some embodiments, the sensors 380 include a current sensor which is configured to measure a voltage drop across the sense resistors 340 and 342 and determine a magnitude of current flowing in the hot line path and neutral line paths between the AC mains 10 and the load 20 based on the measured voltage drops across the current sense resistors 340 and 342. In some embodiments, the sense resistors 340 and 342 have very small resistance values (e.g., on the order of 10x less than 1 milli-Ohm), and as such the voltage potential across the sense resistors 340 and 342 is negligible but yet sufficient for current sensing. The operational amplifiers 350 and 352 are configured with sufficient gain to be able to drive the respective control switches 360 and 362, even with a relatively small voltage input corresponding to the voltage drops across the sense resistors 340 and 342.

In other embodiments, the sensors 380 include one or more sensors that are configured to sense environmental conditions. For example, the sensors 380 can include one or more of (i) a chemical sensitive detector that is configured to detect the presence of hazardous chemicals, (ii) a gas sensitive detector that is configured to detect the presence of hazardous gases, (iii) a temperature sensor that is configured to detect high temperatures indicative of, e.g., a fire; a (iv) a piezoelectric detector that is configured to detect large vibrations associated with, e.g., explosions, earthquakes, etc., (v) a humidity sensor or water sensor that is configured to detect floods or damp conditions, and other types of sensors that are configured to detect for the presence or occurrence of hazardous environmental conditions that would warrant circuit interruption.

In some embodiments, the control switches 370 and 372 comprise optical transistors (e.g., phototransistor, etc.) or other types of optically controlled switches which receive signals from complementary light emitting diodes (LED) that are controlled by, e.g., a sensor device or a microcontroller. This optical coupling between the sensors 380 and the control switches 370 and 372 essentially provides galvanic isolation between the force turn-off control circuit and the switching circuit of the solid-state circuit interrupter 300. In other embodiments, galvanic isolation can be implemented using magnetic, capacitive, or radio frequency (RF) isolation technologies.

In other embodiments, the control switches 370 and 372 can be activated in response to remote commands (e.g., alarm signals) received from a local or remote controller that is configured to detect faults, or remote commands received from an individual that can control operation of the solid-state circuit interrupter 300 through smart technologies implemented using, for example, an Internet-of-Things (IoT) wireless computing network, wherein the solid-state circuit interrupter 300 comprises a smart wireless IoT device.

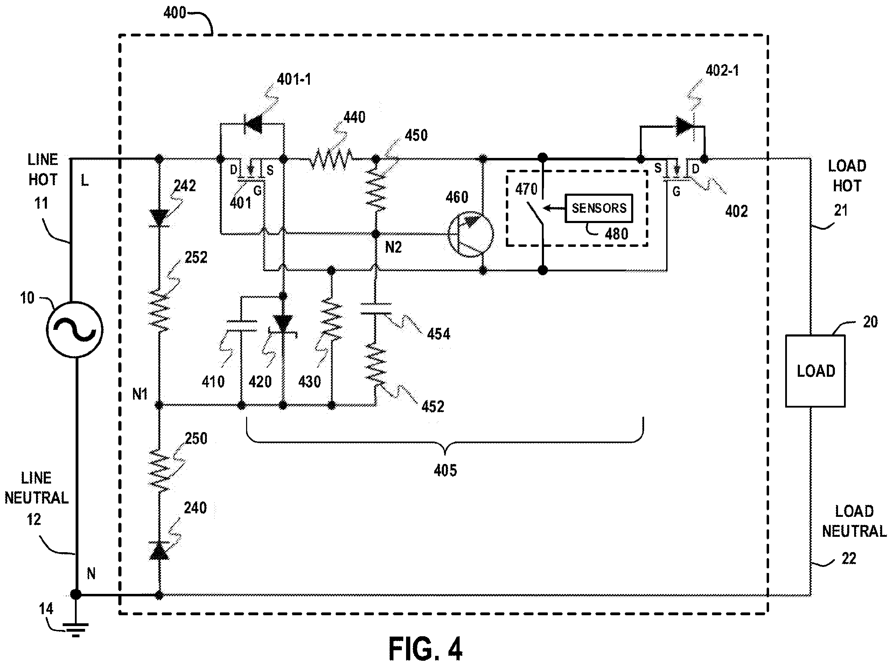

FIG. 4 schematically illustrates a solid-state circuit interrupter according to another embodiment of the invention.

In particular, FIG. 4 illustrates a solid-state circuit interrupter 400 connected between an AC mains 10 and a load 20. The solid-state circuit interrupter 400 comprises a single pole switch circuit which comprises a first solid-state switch 401 and associated body diode 401-1, and a second solid-state switch 402 and associated body diode 402-1. The first and second solid-state switches 401 and 402 are serially connected in the electrical path between the line hot 11 and the load hot 21, with source terminals (S) serially connected through a sense resistor 440, to thereby implement a bidirectional solid-state switch. The solid-state circuit interrupter 400 further comprises a first bias branch circuit comprising a first diode 240 and a first resistor 250, and a second bias branch circuit comprising a second diode 242 and a second resistor 252, which are serially connected between the line hot 11 and line neutral 12 as shown.

The solid-state interrupter 400 further comprises a mode control circuit 405 which comprises a first capacitor 410, a Zener diode 420, resistors 430, 440, 450, and 452, a second capacitor 454, a first control switch 460, a second control switch 470, and sensors 480. The first and second bias branch circuits are connected to an input node N1 of the mode control circuit 405. The mode control circuit 405 shown in FIG. 4 comprises another exemplary embodiment for implementing each of the mode control circuits 220 and 222 of FIG. 2. The mode control circuit 405 is configured to implement (i) a self-bias turn-on threshold voltage control mode using the circuit components 410, 420, 430, 450, 452, 454, and 460 and (ii) a forced turn-off control mode using the circuit components 440, 470 and 480.

For example, for the self-bias turn-on threshold voltage control mode, the resistors 450 and 452 and the capacitor 454 will generate a voltage at node N2 which is sufficient to activate the first control switch 460 and effectively short the gate-to-source of the first and second solid-state switches 401 and 402. The voltage at node N2 will maintain the solid-state switches 401 and 402 turned-off for a delayed time period which corresponds to the RC time constant of the resistor 452 and the capacitor 454.

During this RC time constant delay period, and during a negative half cycle of the AC supply voltage waveform of the AC mains 10, current flows from the line neutral 12 to the line hot 11 through the first branch circuit (comprising the diode 240 and the resistor 250), the capacitor 410, and the body diode 401-1. This current flow causes a voltage across the capacitor 410 to increase until the capacitor voltage reaches target turn-on threshold voltage level across the capacitor 410 which represents a clamping voltage (i.e., Zener voltage of Zener diode 420). In other words, the Zener voltage of the Zener diode 420 limits the maximum level of the self-bias turn-on threshold voltage (V_{GS}) which is generated to turn on the first and second solid-state switches 401 and 402.

In this exemplary embodiment, the target threshold voltage level is limited by the Zener voltage (i.e., reverse breakdown voltage) of the Zener diode 420 such that the Zener diode 420 serves as a solid-state clamp to limit the turn-on threshold voltage. In this regard, the self-bias turn-on threshold voltage control mode is input-line voltage independent, as the level of the self-bias turn-on threshold voltage is limited by the solid-state clamp. During a positive half cycle of AC supply voltage waveform of the AC mains 10, the diode 242, the resistor 252, and the capacitor 410 will trickle charge across the Zener diode 420 to maintain the turn-on threshold voltage (i.e., the Zener voltage) for the first and second solid-state switches 401 and 402.

As noted above, in the exemplary mode control framework of FIG. 4, the solid-state switch 401 is maintained in a switched-off state for a sufficient period of time to charge the capacitor 410 to the Zener voltage of the Zener diode 420. In some embodiments, the Zener voltage is about 15 V, and the turn-on threshold voltage of the solid-state switches 401 and 402 is in a range of about 10 V to about 15 V. If the solid-state switch 401 turns on prematurely before reaching the clamping voltage of the Zener diode due to, e.g., leakage, Miller capacitance of the MOSFET device, etc., the solid-state switch 401 can actually turn on with less than 2 V of gate-to-source voltage, which would prevent the capacitor 410 from being charged enough to generate a capacitor voltage which corresponds to the clamping voltage of the Zener diode 420. In this regard, the self-bias turn-on threshold voltage control mode is configured to maintain the first control switch 460 turned-on for a period of time which is sufficient keep the first and second solid-state switches 401 and 402 turned-off and thereby allow the capacitor 410 to be charged to the clamping voltage of the Zener diode 420.

As noted above, the mode control circuit 405 implements a forced turn-off control mode using the circuit components 440, 470 and 480. In particular, during operation of the solid-state circuit interrupter 400, the switch 470 can be activated by one of the sensors 480 to effectively shunt the gate-to-source terminals and turn-off the solid-state switches 401 and 402. The sensors 480 can include one or more of various types of sensors. For example, in some embodiments, the sensors 480 include a current sensor which is configured to measure a voltage drop across the sense resistor 440 and determine a magnitude of current flowing in the hot line path between the line hot 11 and the load hot 21 based on the measured voltage drop across the current sense resistor 440. In some embodiments, the sense resistor 440 has a resistance value that is less than 1 milli-Ohm. As such, the voltage potential across the sense resistor 440 is negligible but yet sufficient for current sensing. A difference between ground potential of the sense resistor 440 and the sensing circuit is small and will be mutually compensated due to the bi-directional current flow through the sense resistor 440.

In other embodiments, the sensors 480 include one or more sensors that are configured to sense environmental conditions. For example, the sensors 480 can include one or more of (i) a chemical sensitive detector that is configured to detect the presence of hazardous chemicals, (ii) a gas sensitive detector that is configured to detect the presence of hazardous gases, (iii) a temperature sensor that is configured to detect high temperatures indicative of, e.g., a fire; a (iv) a piezoelectric detector that is configured to detect large vibrations associated with, e.g., explosions, earthquakes, etc., (v) a humidity sensor or water sensor that is configured to detect floods or damp conditions, and other types of sensors that are configured to detect for the presence or occurrence of hazardous environmental conditions that would warrant circuit interruption.

In some embodiments, the switch 470 comprises a optical transistor (e.g., phototransistor, etc.) or other types of optical switches, which receives signals from a complementary light emitting diode (LED) that is controlled by a sensor device or microcontroller. This optical coupling between the sensors 480 and the switch 470 essentially provides galvanic isolation between the force turn-off control circuitry and the switching circuit of the solid-state circuit interrupter 400. In other embodiments, galvanic isolation can be implemented using magnetic, capacitive, or radio frequency (RF) isolation technologies.

In other embodiments, the switch 470 can be activated in response to remote commands (e.g., alarm signals) received from a local or remote controller that is configured to detect faults, or remote commands received from an individual that can control operation of the solid-state circuit interrupter 400 through smart technologies implemented using, for example, an IoT wireless computing network, wherein the solid-state circuit interrupter 400 comprises a smart wireless IoT device.

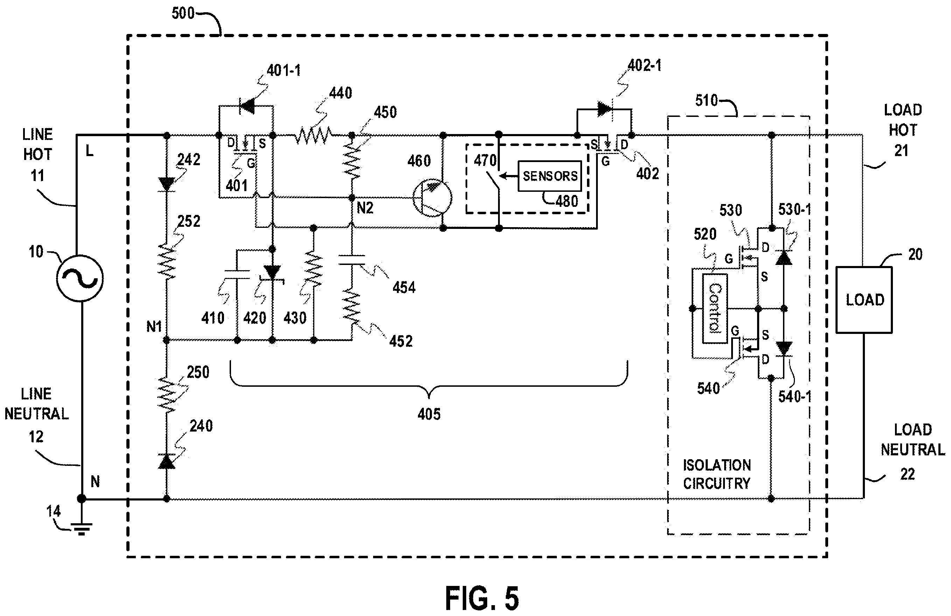

FIG. 5 schematically illustrates a solid-state circuit interrupter according to another embodiment of the invention.

In particular, FIG. 5 schematically illustrates a solid-state circuit interrupter 500 which is similar to the solid-state circuit interrupter 400 of FIG. 4, except that the solid-state circuit interrupter 500 comprises isolation circuity 510 to provide galvanic isolation between the solid-state circuit interrupter 500 and the load 20 when the solid-state switches 401 and 402 are turned off. When the solid-state switches 410 and 402 are turned-off, the solid-state switches 401 and 402 can generate a small amount of leakage current. For example, even when the solid-state switches 401 and 402 are biased to be in a completely switched-off state, a small amount of leakage current (e.g., 200 uA) can flow through the solid-state switches 401 and 402 and generate a sizable voltage drop across the load 20 when the load 20 comprises a high impedance load.

The isolation circuit 510 serves to shunt the load 20 from unwanted leakage current flow from the AC mains 10 though the switched-off solid-state switches 401 and 402. The isolation circuit 510 comprises a controller 520, MOSFET devices 530 and 540 and associated body diodes 530-1 and 540-1. During a turn-off period of the solid-state switches 401 and 402, the controller 520 commands the MOSFET switches 530 and 540 to turn on and thereby shunt the unwanted leakage and prevent such leakage current from flowing into the load 20. The effect of bypassing or shunting leakage current away from the load 20 serves as an equivalent to a galvanic isolation technique which implements with an air-gap between the AC mains 10 and the load 20. In this configuration, the isolation circuitry 510 serves as a pseudo air-gap.

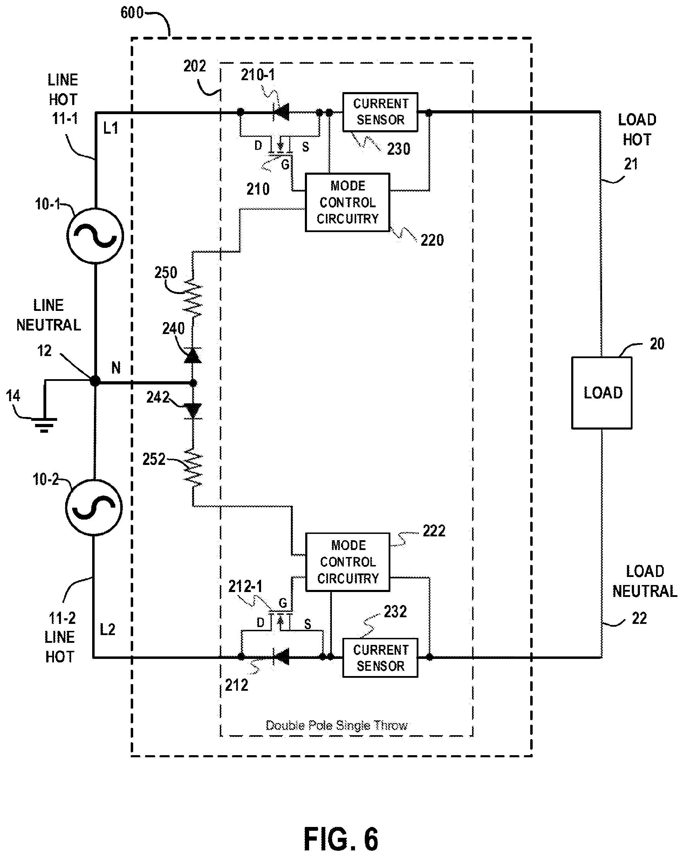

FIG. 6 schematically illustrates a solid-state circuit interrupter according to another embodiment of the invention.

In particular, FIG. 6 schematically illustrates a solid-state circuit interrupter 600 which is similar to the solid-state circuit interrupter 200 of FIG. 2, except that the solid-state switches 210 and 212 of the DPST switching circuit 202 are coupled to the respective line hot lines 11-1 and 11-2 of two separate hot phases 10-1 and 10-2 of the AC mains 10, wherein the hot phases 10-1 and 10-2 are 180 degrees out of phase. In this configuration, the first branch circuit comprising the diode 240 and the resistor 250 are serially connected between the line neutral 12 and the first mode control circuit 220, and the second branch circuit comprising the diode 242 and the resistor 252 are serially connected between the line neutral 12 and the second mode control circuit 222. The mode control circuits 220 and 220 can be implement using the circuit architectures and mode control techniques as discussed above in conjunction with FIGs. 3, 4 and 5.

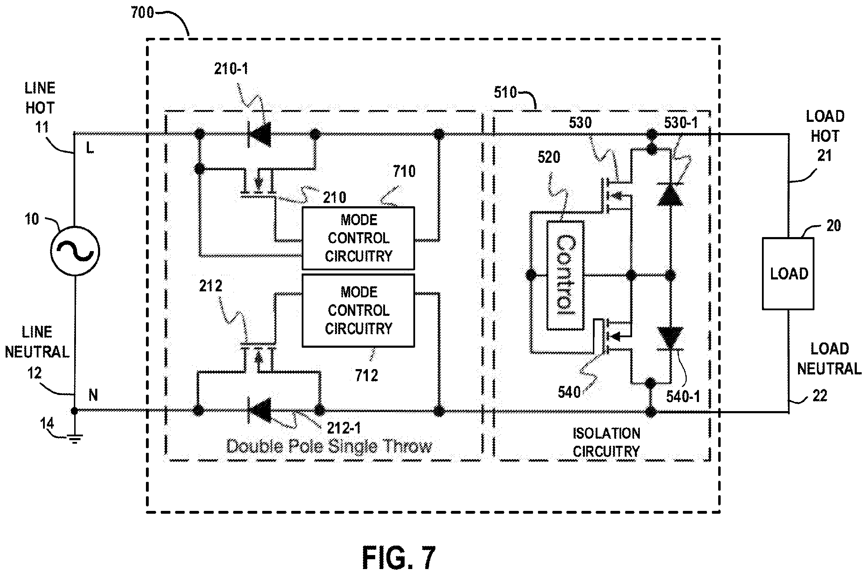

FIG. 7 schematically illustrates a solid-state circuit interrupter according to another embodiment of the invention.

In particular, FIG. 7 schematically illustrates a solid-state circuit interrupter 700 which is similar to the solid-state circuit interrupter 200 of FIG. 2, except that the solid-state circuit interrupter 700 omits the current sensors 230 and 232 shown in FIG. 2, and further includes the isolation circuitry 510 as in the exemplary embodiment of FIG. 5. The isolation circuitry 510 shunts the leakage current, which is generated by the solid-state switches 210 and 212 in their switched-off states, and thereby prevents the leakage current from flowing through the load 20. As noted above, the effect by bypassing or shunting leakage current away from the load 20 serves as an equivalent to galvanic isolation.

While the explicit current sensors 230 and 232 are omitted in the solid-state circuit interrupter 700, a fault detection sensor within one or both of the mode control circuits 710 and 712 can utilize the internal drain-source resistance (R_{DS}-ON) of the solid-state switches 210 and 212 to determine an amount of current flow in the line hot or line neutral legs, and then deactivate the switches 210 and 212 in response to the detection of fault conditions (e.g. short-circuit or over-current faults), and activate the isolation circuit 510 to shunt leakage current from the load 20 during the time when the solid-state switches 210 and 212 are maintained in a switched-off state.

In some embodiments, the mode control circuits 710 and 712 can implement a self-bias turn-on threshold voltage mode utilizing a free-standing isolated AC-DC power supply with floating voltage output that serves as a turn-on threshold voltage to bias the solid-state switches 210 and 212. In other embodiments, a self-bias turn-on threshold voltage mode can be implemented using galvanic isolation devices such as capacitive, RF, and optical isolation devices.

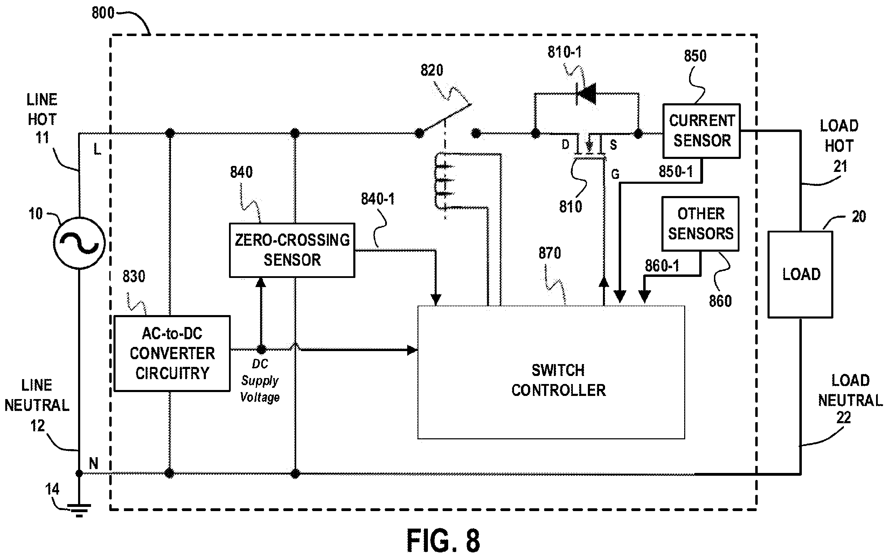

FIG. 8 schematically illustrates a solid-state circuit interrupter according to an example which is not part of the invention.

In particular, FIG. 8 schematically illustrates a solid-state circuit interrupter 800 connected between an AC mains 10 and a load 20, wherein the solid-state circuit interrupter 800 comprises a single pole hybrid solid-state and mechanical circuit interrupter architecture. The solid-state circuit interrupter 800 comprises a solid-state switch 810 and an air-gap electromagnetic switch 820 connected in series in an electrical path between the line hot 11 of the AC mains 10 and the load hot 21 of the load 20 (e.g., the air-gap electromagnetic switch 820 and the solid-state switch 810 are connected in series between a line input terminal and a load output terminal of the solid-state circuit interrupter 800). The solid-state circuit interrupter 800 further comprises an AC-to-DC converter circuit 830, a zero-crossing sensor 840, a current sensor 850, other types of sensors 860 (e.g., environmental sensors, light sensors, etc.), and a switch controller 870.

In some examples as shown in FIG. 8, the solid-state switch 810 comprises a power MOSFET switch 810 (e.g., N-type enhancement MOSFET device) having gate terminals (G), drain terminals (D), and source terminals (S) as shown, and an intrinsic body diode 810-1. The air-gap electromagnetic switch 820 comprises any suitable type of electromagnetic switch mechanism which is configured to physically open and close a set of electrical contacts, wherein an air gap is created between the electrical contacts when the air-gap electromagnetic switch 820 is in a switched-open state. For example, the air-gap electromagnetic switch 820 may comprise a latching solenoid or relay element that is responsive to control signals from the switch controller 870 to automatically open or close the electrical contacts of the air-gap electromagnetic switch 820.

The creation of an air gap in the line path between the line hot 11 and load hot 21 provides complete isolation of the AC mains 10 from the load 20, as it prevents the flow of current from the line hot 11 to the load hot 21. The air-gap electromagnetic switch 820 may be disposed on either the line side (as shown in FIG. 8) of the solid-state switch 810 or on the load side of the solid-state switch 810. The solid-state circuit interrupter 800 provides a cost-effective solution which allows one solid-state switch to be utilized (as compared to several solid-state switches in the exemplary embodiments described above) in an instance where electrical codes require the implementation of an air-gap in the circuit interrupter for complete isolation.

The AC-to-DC converter circuitry 830 is configured to provide DC supply power to various circuitry and elements of the sold-state circuit interrupter 800 including the zero crossing sensor 840, the switch controller 860, and optionally the current sensor 850 and other sensors 860 (depending on the configuration of such sensors 850 and 860). The AC-to-DC converter circuitry 830 is configured to remain powered during faults when the switches 810 and 820 are respectively switched-Off and switched-Open states. In some embodiments, the AC-to-DC converter circuitry 830 comprises sufficient storage capacitance to power the DC subsystems immediately following a utility outage such that relevant power outage or short-circuit information may be obtained and stored by the switch controller 870 as the utility power collapses, and then wirelessly transmitted to a remote node, device, or system using a radio frequency transceiver (not shown) which is either coupled to the switch controller 870 or integrated with the switch controller 870.

The zero-crossing sensor 840 is configured to monitor the voltage and/or current at a target point along the hot line path through the solid-state circuit interrupter 800 and detect zero current and/or zero voltage crossings of the AC supply voltage waveform of the AC mains 10. For example, as shown in FIG. 8, the zero-crossing sensor 840 is coupled to the hot line path upstream of the switches 820 and 810 to detect instances of zero current and/or zero voltage crossings of the AC power supply waveform of the AC mains 10 on the line input of the solid-state circuit interrupter 800. The zero-crossing sensor 840 is coupled to the switch controller 870 by one or more data acquisition and control lines 840-1. The zero-crossing sensor 840 can be implemented using any suitable type of zero voltage and/or zero current sensing circuitry that is configured to sense zero crossings of current and or voltage of the AC power supply waveform and generate a detection signal that indicates a zero-crossing event and an associated direction of the current or voltage (e.g., transitioning from negative to positive, or from positive to negative). In this regard, the zero-crossing sensor 840 is configured to receive as input an AC waveform, compare the input AC waveform to a zero reference voltage (e.g., line neutral voltage), and detect the AC waveform transition from positive and negative, which coincides when the AC waveform crosses the zero reference voltage. The zero-crossing detector will transition between a logic "1" and logic "0" output upon each detected zero crossing of the AC voltage waveform.

The current sensor 850 is configured to detect a magnitude of current being drawn by the load 20 in the hot line path through the solid-state circuit interrupter 800. The current sensor 850 can be implemented using any suitable type of current sensing circuit including, but not limited to, a current-sensing resistor, a current amplifier, a Hall Effect current sensor, etc. The current sensor 850 is coupled to the switch controller 870 by one or more data acquisition and control lines 850-1.

The sensors 860 include one or more optional sensors that are configured to detect for possible hazardous environmental conditions (e.g., chemical, gas, humidity, water, temperature, light, etc.) and generate sensor data that is indicative of potentially hazardous environmental conditions. The sensors 860 are coupled to the switch controller 870 by one or more data acquisition and control lines 860-1.

The switch controller 870 operates in conjunction with the zero-crossing sensor 840, the current sensor 850 and the sensors 860 to perform functions such as detecting fault conditions (e.g., short-circuit faults, over-current faults, arc faults, ground faults, etc.), detecting hazardous environmental conditions (e.g., gas leaks, chemical spills, fire, floods, etc.), and to provide timing control for the opening and closing of the switches 810 and 820 in response to detected fault conditions or hazardous environmental conditions, to thereby avoid creating electrical arcs in the air-gap electromagnetic switch 820. The switch controller 870 generates gate control signals that are applied to the gate terminal (G) of the solid-state switch 810 to place the solid-state switch 810 into a switched-on or a switched-off state. In some embodiments, the switch controller 870 generates a gate control signal to place the solid-state switch 810 into a switched-off state in response to fault conditions such as short-circuit faults, over-current faults, and other faults or hazards that are detected by the switch controller 870 as a result of analyzing sensor data obtained from the current sensor 850 and/or the other sensors 860.

The switch controller 870 can be implemented using a processor that is configured to process sensor data and implement switch control timing protocols as discussed herein for controlling the switches 810 and 820. In addition, the switch controller 870 can implement circuity for converting the sensor data into proper formats that are suitable for processing by the processor. The switch controller 870 can include an RF transceiver to wirelessly communicate with a remote node, device, system, etc., to support remote monitoring and detection of fault conditions and receiving remote commands for controlling the solid-state circuit interrupter 800. The processor may comprise a central processing unit, a microprocessor, a microcontroller, an application-specific integrated circuit (ASIC), a field programmable gate array (FPGA), and other types of processors, as well as portions or combinations of such processors, which can perform processing functions based on software, hardware, firmware, etc. In other embodiments, the solid-state circuitry of the various components (e.g., 830, 840, and 870) of the circuit interrupter 800 can be implemented on a single die as a system-on-chip.

To prevent the generation of electrical arcs between the electrical contacts of the electromagnetic switch 820, the switch controller 870 is configured place the solid-state switch 810 into a switched-off state before placing the air-gap electromagnetic switch 820 into a switched-open or switched-closed state. However, in the configuration of FIG. 8, even when the solid-state switch 810 is in a switched-off state, and assuming the air-gap electromagnetic switch 820 is in a switched-closed state, the body diode 810-1 of the solid-state switch 810 will allow negative current to conduct from the load 20 to the AC mains 10 when the AC power supply waveform of the AC mains 10 is in a negative half-cycle (i.e., when the line hot 11 is negative and the line neutral 12 is positive). Indeed, in this configuration, during a negative half-cycle, the body diode 810-1 is in a forward-biased state, which allows negative current to flow from the load 20 to the AC mains 10, even when the solid-state switch 810 is in a switched-off state.

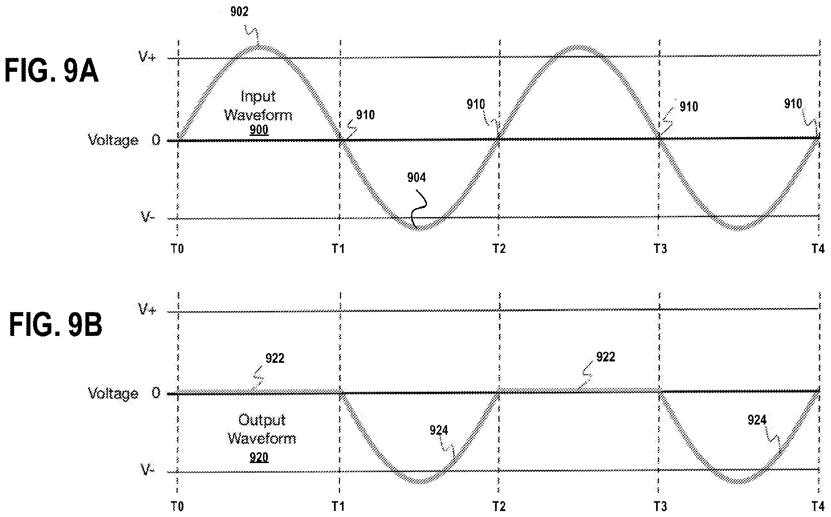

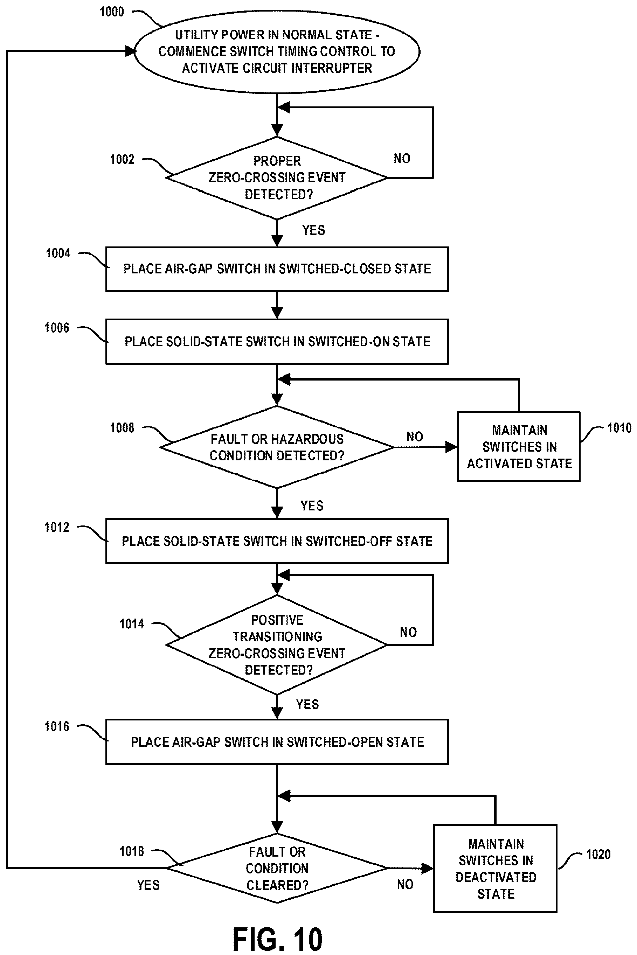

In this instance, if the air-gap electromagnetic switch 820 is opened during the negative half cycle of the AC power supply waveform, the flow of negative current would generate electrical arcs between the electrical contacts of the air-gap electromagnetic switch 820. To avoid creating such electrical arcs, the switch controller 870 is configured to configured to place the solid-state switch 810 in a switched-off state and then track sensor data obtained from the zero-crossing sensor 840 to determine the polarity of the AC voltage and/or current on the line side (e.g., line hot 11) of the solid-state interrupter 800, and open the air-gap electromagnetic switch 820 when the polarity of the AC voltage and/or current on the line side is determined to be positive (e.g., the AC supply voltage waveform is in a positive half cycle). When the switch controller 870 determines, at a given time, that the polarity of the AC voltage and/or current on the line side is negative (e.g., the AC supply voltage waveform is in a negative half cycle), the switch controller 870 will not open the air-gap electromagnetic switch 820, but rather defer opening the air-gap electromagnetic switch 820 until the next instance of a positive transition zero crossing as detected by the zero-crossing sensor 840. The switch timing control implemented by the switch controller 870 will now be discussed in further detail with reference to FIGs. 9A, 9B and 10.

FIG. 9A illustrates a power supply voltage waveform that is input to a line side of the solid-state circuit interrupter 800 of FIG. 8. In particular, FIG. 9A, illustrates an input voltage waveform 900 which represents a power supply voltage waveform of the AC mains 10. The input voltage waveform 900 comprises positive half cycles 902, negative half cycles 904, and zero voltage crossings 910 at times T0, T1, T2, T3, and T4. When the solid-state switch 810 is in switched-on state and the air-gap electromagnetic switch 820 is in switched-closed state, the input voltage waveform 900 is applied to the load hot line 21 of the load 20. When the switch controller 870 determines that power should be disconnected from the load 20, the switch controller 870 will generate a gate control signal that is applied to the gate terminal G of the solid-state switch 810 to place the solid-state switch 810 into a switched-off state.

FIG. 9B illustrates an output voltage waveform 920 on a load side of the solid-state circuit interrupter 800 of FIG. 8 when the solid-state switch 810 is in a switched-off state and the air-gap electromagnetic switch 820 is in a switched-closed state. In this state, the body diode 810-1 of the solid-state switch 810 is forward biased during the negative half cycles 904 of the input voltage waveform 900, which rectifies the input voltage waveform 900 and results in the output voltage waveform 920 shown in FIG. 9B wherein portions 922 of the output voltage waveform 920 which correspond to the positive half cycles 902 of the input waveform 900 are at 0V, and wherein portions 924 of the output voltage waveform 920 track the voltage of the negative half cycles 904 of the input waveform 900. In this instance, negative current would flow from the load 20 to the AC mains 10 during each negative half cycle 924 until the air-gap electromagnetic switch 820 was opened.

As noted above, after the solid-state switch 810 is switched-off, the switch controller 870 will process sensor data received from the zero-crossing sensor 840 to determine when there is little or no current flow in the line hot path, and then generate a control signal to open the air-gap electromagnetic switch 820 to fully disconnect power to the load 20, while preventing or otherwise mitigating possible electrical arc formation in the air-gap switch 820.

For example, assume that the solid-state switch 810 is switched-off in the time period between T0 and T1 in FIGs. 9A and 9B. In this example, the switch controller 870 would detect that the next zero voltage crossing of the input waveform 900 is a negative transitioning zero voltage crossing 910 at time T1, and then wait for the next positive transitioning zero voltage crossing 910 at time T2 before deactivating the air-gap electromagnetic switch 820 to ensure that no current is flowing in the line hot path between the load 20 and AC mains 10 when the air-gap electromagnetic switch 820 is opened.

It is to be understood that the exemplary voltage waveforms 9A and 9B represent a load 20 having a power factor of about one (1) where is it is assumed that AC voltage waveform and the current drawn by the load 20 are in phase. In such instance, the zero voltage crossings are assumed to be zero current crossings. However, in instances where the load 20 has a power factor that is less than 1 (e.g., capacitive or inductive load), the voltage waveform and current drawn by the load 20 will be out of phase. In this regard, the zero-crossing sensor 840 can include a zero current crossing detector to determine zero current crossings, or positive transitioning zero current crossings, of a current waveform on the line side of the switches 820 and 810 to ensure that no positive current is flowing in the line hot path before opening the air-gap electromagnetic switch 820.

FIG. 10 is a flow diagram of a switch control process which is implemented by the switch controller 870 of the solid-state circuit interrupter 800 of FIG. 8, according to an example of the disclosure. The switch control process of FIG. 10 represents a non-limiting example for recovery of utility power or a manual, automatic, or remote activation control to activate the solid-state interrupter 800 (block 1000). In this example, it is assumed that the solid-state switch 810 is in a switched-off state, and the air-gap electromagnetic switch 820 is in a switched-closed state.

The switch controller 870 waits to detect a proper zero crossing (block 1002) before closing the air-gap electromagnetic switch 820 (block 1004). While it is ideal to wait for a voltage and/or current zero cross event prior to closing the air-gap electromagnetic switch 820, one of ordinary skill in the art will understand that this is not a mandatory condition for closure. The zero-crossing event can be a positive transitioning zero-crossing event or a negative transitioning zero-crossing event. As noted above, in some examples, it is preferable to close the air-gap electromagnetic switch 820 at the zero-crossing of an upcoming half cycle in which the body diode (e.g., diode 810-1) of the solid-state switch (e.g., switch 810) is not forward biased and conducting. For example, in the example of FIG. 8, the body diode 810-1 of the solid-state switch 810 is reversed biased and nonconducting during positive half cycles of the supply voltage waveform of the AC mains 10. In such embodiment, it is ideal to place the air-gap electromagnetic switch into a switched-closed state (block 1004) upon detecting a positive transitioning (current or voltage) zero-crossing event. In other examples, depending on the type of MOSFET being used for the solid-state switch and associated body diode, it may be ideal to close the solid-state switch upon detecting a negative transitioning (current or voltage) zero-crossing event.

When the air-gap electromagnetic switch 820 is closed, the switch controller 870 will proceed to generate a gate control signal to place the solid-state switch 810 into a switched-on state (block 1006). The solid-state switch 810 may be switched-on at any time after the air-gap electromagnetic switch 820 is closed. For example, the solid-state interrupter circuit 800 may operate in a "stand-by" mode where the air-gap electromagnetic switch 820 is maintained in switched-closed state, and the switch controller 870 waits for the occurrence of some triggering event (e.g., remote command) to proceed with activating the solid-state switch 810.

When both switches 810 and 820 are activated, the switch controller 870 will enter a waiting state for some event or command to interrupt the circuit connection between power and load (block 1008). During the waiting period, the solid-state switch 810 and the air-gap electromagnetic switch 820 will be maintained in a activated state (block 1010). The event can be the detection of a given fault condition or hazardous condition as determined by the switch controller 870 processing sensor data received from the various sensors 850 and 860. The command can be a manual command or automated command to interrupt the circuit connection.

Upon detecting a fault or hazardous condition (affirmative determination in block 1008) or in response to a manual or automated command to interrupt the circuit, the switch controller 870 will generate a gate control signal to place the solid-state switch 810 into a switched-off state (block 1012). The switch controller 870 will then proceed to process data from the zero-crossing sensor 840 to detect a target zero-crossing event (e.g., a positive transitioning zero-crossing event) on the line hot path (block 1014), and in response to detecting the target zero-crossing event (affirmative determination in block 1014), the switch controller 870 will generate a switch control signal to place the air-gap electromagnetic switch 820 into a switched-open state (block 1016).

The switch controller 870 will enter a wait state (block 1018) to wait for the fault event or hazardous condition to be cleared, and maintain the solid-state and air-gap electromagnetic switches in a deactivate state (block 1020). When the fault event or hazardous condition is cleared (affirmative determination in block 1018), or when the switch controller 870 otherwise receives a manual or remote command indicating to reconnect power to the load, the control process returns to block 1000, wherein the switch controller 870 proceeds to reactivate the air-gap and solid-state switches and, thereby reconnect the power supply to the load. It is to be understood that while the process flow of FIG. 10 does not explicitly include process steps for performing zero-crossing detection prior to opening and closing the solid-state switch 810, one of ordinary skill in the art will recognize and appreciate that for certain applications, the switching on and off of the solid-state switch 810 may be timed with either a voltage or current zero-crossing event, as desired.

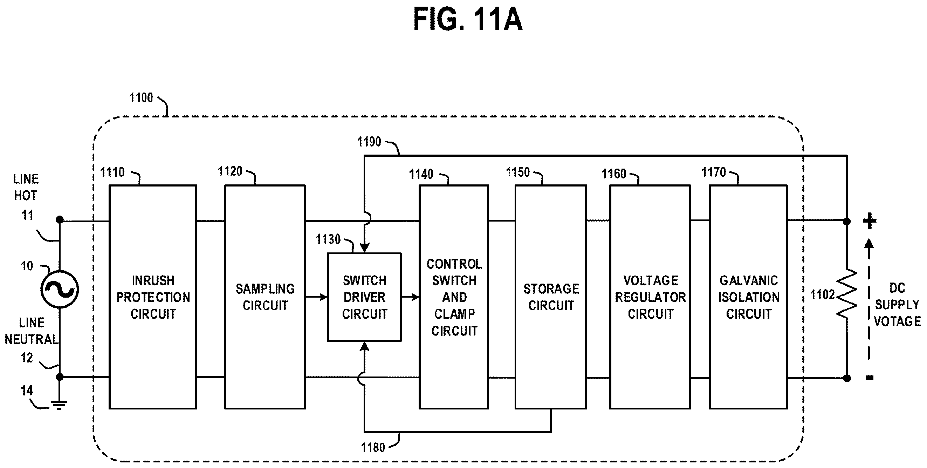

FIG. 11A is a schematic block diagram of an AC-to-DC converter circuit 1100 which can implemented in the solid-state circuit interrupter 800 of FIG. 8, according to an example of the disclosure. The AC-to-DC converter circuit 1100 comprises an architecture which does not require a rectifier to generate DC voltage. The AC-to-DC converter circuit 1100 comprises an inrush protection circuit 1110, a sampling circuit 1120, a switch driver circuit 1130, a control switch and clamp circuit 1140, a storage circuit 1150, a voltage regulator circuit 1160, and a galvanic isolation circuit 1170. The AC-to-DC converter circuit 1100 generates a DC supply voltage that is applied to load circuitry 1102.

The inrush protection circuit 1110 is configured to limit the magnitude of input current to the AC-to-DC converter circuit 1100. The sampling circuit 1120 is configured to sample the AC supply voltage waveform of AC mains 110. The sampling circuit 1120 outputs sampled voltages to the switch driver circuit 1130. The switch driver circuit 1130 is configured to apply a control voltage to a control switch of the control switch and clamp circuit 1140. The control switch and clamp circuit 1140 is configured to supply power to the storage circuit 1150 in response to the control voltage applied by the switch driver circuit 1130. The storage circuit 1150 comprises a voltage storage element (e.g., capacitor) that is configured to store a DC voltage that is applied to the voltage regulator circuit 1160. The voltage regulator circuit 1160 is configured to generate a regulated DC supply voltage to the load circuitry 1102.

In some examples, the switch driver circuit 1130 receives a feedback voltage 1180 from the storage circuit 1150 and generates the control voltage that is applied to the control switch and clamp circuit 1140 based, at least in part, on the feedback voltage 1180. In some other examples, the feedback voltage 1180 can be eliminated, and the AC-to-DC converter circuit 1100 operates as a feed forward converter in which the storage element of the storage circuit 1150 is controlled from the forward side elements 1120, 1130 and 1140.

In some examples, the AC-to-DC converter circuitry 1100 implements a feedback control circuit 1190 from the load circuitry 1102 to the switch driver circuit 1130 to support both feed forward and feedback control. In some other example, the balance of feed forward and feedback control is determined by the feedback voltage 1180 and the selection of components in the sampling circuitry 1120. In some other examples, a balance between feedforward and feedback control is configured according to resistor elements in the sampling circuitry 1120 and the feedback voltage 1180. In other examples, variable elements are utilized to enable adjustment of the feedforward and feedback control. In such examples, the feedback circuit 1190 would comprise galvanic isolation between the switch driver circuit 1130 and the load circuitry 1102.

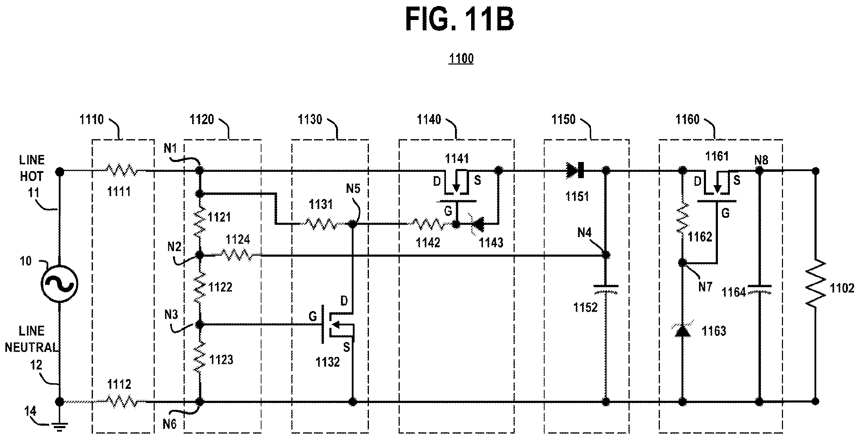

FIG. 11B is a schematic circuit diagram of the AC-to-DC converter circuit of FIG. 11A, according to an example of the disclosure. In the example of FIG 11B, the inrush protection circuitry 1110 comprises a first input resistor 1111 connected to the line hot 11 of the AC mains 10 and a second input resistor 1112 connected to the line neutral 12 of the AC mains 10. In other examples, for high-power and high-efficiency applications, the inrush protection circuitry 1110 comprises switch elements that are configured to allow current to flow through the resistors 1111 and 1112 at startup, and then bypass the resistors 1111 and 1112 once steady state operation is reached. In other examples, the inrush protection circuitry 1110 comprises first and second inductor elements in place of the first and second resistors 1111 and 1112.

The sampling circuitry 1120 comprises a plurality of resistors 1121, 1122, 1123, and 1124 which are connected to various nodes N1, N2, N3, and N4 as shown. The resistors 1121, 1122, and 1123 form a voltage divider network for sampling the input AC waveform, wherein the voltage divider network comprises a feedback node N2 and an output node N3. The resistor 1124 is connected between the feedback node N2 and an output node N4 of the storage circuitry 1150 to provide a feedback voltage from the storage capacitor 1152. The switch driver circuitry 1130 comprises a resistor 1131 connected between nodes N1 and N5, and a switch element 1132. The control switch and clamp circuitry 1140 comprises a control switch element 1141, a resistor 1142, and a Zener diode 1143. The storage circuitry 1150 comprises a diode 1151 and a storage capacitor 1152. The voltage regulator circuitry 1160 comprises a switch element 1161, a resistor 1162, a Zener diode 1163, and a capacitor 1164.

In some examples, the switch elements 1132, 1141 and 1161 comprise n-type enhancement MOSFET devices with gate G, drain D and source S terminals as shown in FIG. 11B. In other examples, the switch elements 1132, 1141 and 1161 may be implemented using bipolar transistors or microelectromechanical switches. As shown in FIG. 11B, the switch element 1143 comprises a gate terminal G connected to the output node N3 of the voltage divider network of the sampling circuitry 1120, a drain terminal D connected to an output node N5 of the switch driver circuitry 1130, and a source terminal S connected to an output node N3 of the inrush protection circuitry 1110. The drain terminal D of the switch element 1132 is coupled to the output node N1 of the inrush protection circuitry 1110 through the resistor 1131.

The control switch 1141 comprises a drain terminal D connected to the output node N1 of the inrush circuitry 1110, a gate terminal G connected to the output node N5 of the switch driver circuitry, and a source terminal S connected to an input (i.e., anode of diode 1151) of the storage circuitry 1150. The Zener diode 1143 is connected between the gate terminal G and source terminal S of the control switch 1141, with a cathode of the Zener diode 1143 connected to the gate terminal G of the control switch 1141 and an anode of the Zener diode 1143 connected to the source terminal S of the control switch 1141.

The switch element 1161 of the voltage regulator circuitry 1160 comprises a drain terminal D connected to the output node N4 of the storage circuitry 1150, a gate terminal G connected to a node N7 between the resistor 1162 and the Zener diode 1163, and a source terminal S connected to an output node N8 of the voltage regulator circuitry 1160. The capacitor 1164 is connected between the output node N8 of the voltage regulator circuitry 1160 and the output node N6 of the inrush protection circuitry 1110.

The resistor 1124 (or sense resistor) is connected between the output node N4 of the storage circuitry 1150 to provide a feedback voltage that is applied to the feedback node N2 of the sampling circuitry 1120 through the feedback resistor 1124. The feedback path provided by the connection of the feedback resistor 1124 between nodes N4 and N2 provides an exemplary embodiment of the feedback voltage 1180 as shown in FIG. 11A, wherein the charge of the storage capacitor 1152 is utilized, in part, to generate a control voltage at the output node N3 of the sampling circuitry 1120 connected to the gate terminal G of the switch element 1132 of the switch driver circuitry 1130.

The switch element 1132 is driven by a gate control voltage generated at the output node N3 of the voltage divider network of the sampling circuitry 1120. The gating of the switch element 1132 controls operation of the control switch 1141 of the switch driver circuitry 1130. The resistance values of the resistors 1121, 1122, 1123, and 1124 are selected such that the voltage on node N3 of the voltage divider network, which is applied to the gate terminal G of the switch element 1132 in the switch driver circuitry 1130, will turn the switch element 1132 ON and OFF and thereby synchronously turn the control switch element 1141 OFF and ON. The control switch element 1141 is thereby driven to output a preselected timed output pulse to charge the storage capacitor 1152.

The peak output current of the control switch 1141 is clamped to a preselected value based on a preselected value of the Zener voltage (i.e., reverse breakdown voltage) of the Zener diode 1143, wherein the maximum gate-to-source voltage (V_{GS}) is limited by the Zener voltage of the Zener diode 1143. The pulsed output from the control switch 1141 operates to turn on the diode 1151 and supply charge to the node N4 to charge the storage capacitor 1152. The feedback provided by the resistor 1124 connected between the output node N4 of the storage circuitry 1160 and the feedback node N2 of the sampling circuitry 1120 serves to drive the switch driver circuit 1130 to maintain the storage capacitor 1152 to a constant charge.

The switch element 1132 and control switch 1141 are activated, either opened or closed, in synch with the AC voltage input. The AC-to-DC converter circuit 1100 provides a low voltage output with pulse modulation at the frequency of the incoming AC source. The switches 1132 and 1141 are activated, either opened or closed, at voltages that are near, within the threshold voltages for the switches 1132 and 1141, of the zero crossing of the AC source. The output node N4 of the storage circuitry 1150 is applied to an input of the voltage regulator circuitry 1160 and then the load circuit 1102. The capacitor 1164 provides storage capacity to buffer and thereby smooth the output from the AC-to-DC converter 1100 to the load circuitry 1102.

In summary, the exemplary AC-to-DC converter circuits 1100 as shown in FIGs. 11A and 11B comprise the inrush protection circuit 1110, the voltage sampling circuit 1120, the switch driver circuit 1130, the control switch and clamp circuit 1140, the storage circuit 1150, and the voltage regulator circuit 1160. The selection of components in the voltage sampling circuit 1120 determine the timing of the switch driver 1130. The selection of components of the control switch and clamping circuit 1140 determine a peak voltage and current for out pulses. Power output is controlled by selection of both the peak current and the pulse timing. Feedback from the storage element 1152 through the voltage sampling circuit 1120 is utilized to select the pulse timing. The AC-to-DC converter circuit 1100 operates in sync with the AC voltage waveform of the AC mains 110.

Although exemplary embodiments of the invention have been described herein with reference to the accompanying figures, it is to be understood that the invention is not limited to those precise embodiments, and that various other changes and modifications may be made therein by one skilled in the art without departing from the scope of the appended claims.

## Claims

1. A circuit interrupter (100, 200, 300, 400, 500, 600, 700), comprising:
a solid-state switch (210, 212, 401, 402) serially connected between a line input terminal and a load output terminal of the circuit interrupter, and configured to be placed in one of i) a switched-on state to provide an electrical connection in an electrical path between the line input terminal and the load output terminal, and ii) a switched-off state; and
a mode control circuit (220, 222, 405, 710, 712) configured to implement a first control mode and a second control mode to control operation of the circuit interrupter;
wherein in the first control mode, the mode control circuit (220, 222, 405, 710, 712) is configured to i) utilize current drawn from an input power source (10, 10-1, 10-2) when applied to the line input terminal of the circuit interrupter to generate a turn-on threshold voltage during power-up of the circuit interrupter, ii) couple a gate terminal (G) of the solid-state switch (210, 212, 401, 402) to a source terminal (S) of the solid-state switch (210, 212, 401, 402) during the power-up of the circuit interrupter to maintain the solid-state switch (210, 212, 401, 402) in the switched-off state until the turn-on threshold voltage is generated to a constant target voltage level, and iii) decouple the gate terminal (G) of the solid-state switch (210, 212, 401, 402) from the source terminal (S) of the solid-state switch (210, 212, 401, 402) to thereby apply the turn-on threshold voltage at the constant target voltage level to the gate terminal (G) of the solid-state switch (210, 212, 401, 402) to place the solid-state switch (210, 212, 401, 402) into the switched-on state; and
wherein in the second control mode, the mode control circuit (220, 222, 405, 710, 712) is configured to couple the gate terminal (G) of the solid-state switch (210, 212, 401, 402) to the source terminal (S) of the solid-state switch (210, 212, 401, 402) to disrupt the turn-on threshold voltage applied to the gate terminal (G) of the solid-state switch (210, 212, 401, 402) and thereby place the solid-state switch (210, 212, 401, 402) into the switched-off state.

2. The circuit interrupter (100, 200, 300, 400, 500, 600, 700) of claim 1, wherein the mode control circuit (220, 222, 405, 710, 712) comprises:
a self-biasing circuit comprising a voltage clamping circuit and a first control switch (360, 362, 460);
wherein the voltage clamping circuit is configured to generate the turn-on threshold voltage during power-up of the circuit interrupter using current drawn from the input power source (10, 10-1, 10-2) when applied to the line input terminal of the circuit interrupter; and
wherein in response to activation of the first control switch (360, 362, 460), the first control switch (360, 362, 460) is configured to couple the gate terminal of the solid-state switch (210, 212, 401, 402) to the source terminal of the solid-state switch (210, 212, 401, 402) to maintain the solid-state switch (210, 212, 401, 402) in the switched-off state until the turn-on threshold voltage is generated to the constant target voltage level.

3. The circuit interrupter (100, 200, 300, 400, 500, 600, 700) of claim 2, wherein the voltage clamping circuit comprises a capacitor (310, 312, 410) and a Zener diode (320, 322, 420) connected in parallel.

4. The circuit interrupter (100, 200, 400, 500, 600, 700) of claim 2, wherein the self-biasing circuit comprises a resistor-capacitor (RC) network (452, 454) coupled to a control terminal of the first control switch (460), wherein the RC network (452, 454) is charged during the power-up of the circuit interrupter using current drawn from the input power source (10, 10-1, 10-2) when applied to the line input terminal of the circuit interrupter, wherein the RC network (452, 454) is configured to have an RC time constant which corresponds to a time period that is not less than a time period needed to generate the turn-on threshold voltage to the constant target voltage level during power-up of the circuit interrupter.

5. The circuit interrupter (100, 200, 300, 600, 700) of claim 2, wherein the self-biasing circuit comprises an operational amplifier (350, 352) having an input connected to the voltage clamping circuit and an output connected to a control terminal of the first control switch (360, 362), wherein the operational amplifier (350, 352) is configured to control operation of the first control switch (360, 362) by maintaining the first control switch (360, 362) in a switched-on state during generation of the turn-on threshold voltage, and placing the first control switch (360, 362) into a switched-off state after the turn-on threshold voltage is generated.

6. The circuit interrupter (100, 200, 300, 400, 500, 600, 700) of claim 2, wherein the mode control circuit (220, 222, 405, 710, 712) comprises a second control switch (370, 372, 470) which is configured to couple the gate terminal of the solid-state switch (210, 212, 401, 402) to the source terminal of the solid-state switch (210, 212, 401, 402) and disrupt the turn-on threshold voltage applied to the control terminal of the solid-state switch (210, 212, 401, 402) and thereby place the solid-state switch (210, 212, 401, 402) into a switched-off state, in response to activation of the second control switch (370, 372, 470).

7. The circuit interrupter (100, 200, 300, 400, 500, 600, 700) of claim 6, further comprising a sensor circuit (230, 232, 380, 480) which is configured to generate a control signal to activate the second control switch (370, 372, 470) in response to the sensor circuit (230, 232, 380, 480) detecting a condition that warrants placing the solid-state switch (210, 212, 401, 402) into the switched-off state.

8. The circuit interrupter (100, 200, 300, 400, 500, 600, 700) of claim 7, wherein the sensor circuit (230, 232, 380, 480) comprises a current sensor which is configured to sense a current flowing in the electrical path between the line input terminal and the load output terminal, and detect a fault condition, wherein the fault condition comprises one of a short-circuit fault condition, an over-current fault condition, an arc-fault condition, and a ground-fault condition.

9. The circuit interrupter (100, 200, 300, 400, 500, 600, 700) of claim 7, wherein the sensor circuit (230, 232, 380, 480) comprises an environmental sensor circuit (380, 480) which is configured to sense a hazardous environmental condition.

10. The circuit interrupter (100, 200, 300, 400, 500, 600, 700) of claim 9, wherein the environmental sensor circuit (380, 480) comprises one or more of i) a chemical sensitive detector that is configured to detect a presence of hazardous chemicals, ii) a gas sensitive detector that is configured to detect a presence of hazardous gases, iii) a temperature sensor that is configured to detect a temperature, iv) a piezoelectric detector that is configured to detect vibrations; and v) a humidity sensor that is configured to detect a damp environment.

11. The circuit interrupter (100, 200, 300, 400, 500, 600, 700) of claim 7, wherein the second control switch (370, 372, 470) comprises a phototransistor and wherein the sensor circuit is optically coupled to the phototransistor such that the phototransistor is activated in response to optical control signals.

12. The circuit interrupter (100, 200, 300, 400, 500, 600, 700) of claim 6, wherein the second control switch (370, 372, 470) comprises a phototransistor and wherein the phototransistor is activated in response to optical control signals.

13. An electrical circuit breaker comprising the circuit interrupter (100, 200, 300, 400, 500, 600, 700) of claim 1.

14. An electrical receptacle device comprising the circuit interrupter (100, 200, 300, 400, 500, 600, 700) of claim 1.

15. An electrical light switch comprising the circuit interrupter (100, 200, 300, 400, 500, 600, 700) of claim 1.

## Patentansprüche

1. Schaltungsunterbrecher (100, 200, 300, 400, 500, 600, 700), umfassend:
einen Halbleiterschalter (210, 212, 401, 402), der zwischen einem Leitungseingangsanschluss und einem Lastausgangsanschluss des Leitungsunterbrechers in Reihe geschaltet ist und konfiguriert ist, um in einen von i) einem eingeschalteten Zustand, um eine elektrische Verbindung in einem elektrischen Pfad zwischen dem Leitungseingangsanschluss und dem Lastausgangsanschluss bereitzustellen, und ii) einem ausgeschalteten Zustand versetzt zu werden; und
eine Modussteuerungsschaltung (220, 222, 405, 710, 712), die konfiguriert ist, um einen ersten Steuermodus und einen zweiten Steuermodus zu implementieren, um den Betrieb des Schaltungsunterbrechers zu steuern;
wobei im ersten Steuermodus die Modussteuerschaltung (220, 222, 405, 710, 712) konfiguriert ist, um i) Strom zu verwenden, der von einer Eingangsenergiequelle (10, 10-1, 10-2) gezogen wird, wenn er an den Leitungseingangsanschluss des Schaltungsunterbrechers angelegt wird, um eine Einschaltschwellenspannung beim Einschalten des Schaltungsunterbrechers zu erzeugen, ii) einen Gate-Anschluss (G) des Halbleiterschalters (210, 212, 401, 402) mit einem Source-Anschluss (S) des Halbleiterschalters (210, 212, 401, 402) während des Einschaltens des Stromkreisunterbrechers zu koppeln, um den Halbleiterschalter (210, 212, 401, 402) im ausgeschalteten Zustand zu halten, bis die Einschaltschwellenspannung auf einen konstanten Zielspannungspegel erzeugt ist, und hi) den Gate-Anschluss (G) des Halbleiterschalters (210, 212, 401, 402) von dem Source-Anschluss (S) des Halbleiterschalters (210, 212, 401, 402) zu entkoppeln, um dadurch die Einschaltschwellenspannung auf dem konstanten Zielspannungspegel an den Gate-Anschluss (G) des Halbleiterschalters (210, 212, 401, 402) anzulegen, um den Halbleiterschalter (210, 212, 401, 402) in den eingeschalteten Zustand zu bringen; und
wobei im zweiten Steuermodus die Modussteuerschaltung (220, 222, 405, 710, 712) konfiguriert ist, um den Gate-Anschluss (G) des Halbleiterschalters (210, 212, 401, 402) mit dem Source-Anschluss (S) des Halbleiterschalters (210, 212, 401, 402) zu koppeln, um die an den Gate-Anschluss (G) des Halbleiterschalters (210, 212, 401, 402) angelegte Einschaltschwellenspannung zu unterbrechen und dadurch den Halbleiterschalter (210, 212, 401, 402) in den ausgeschalteten Zustand zu bringen.

2. Schaltungsunterbrecher (100, 200, 300, 400, 500, 600, 700) nach Anspruch 1, wobei die Modussteuerungsschaltung (220, 222, 405, 710, 712) Folgendes umfasst:
eine Selbstvorspannungsschaltung, umfassend eine Spannungsklemmschaltung und einen ersten Steuerschalter (360, 362, 460);
wobei die Spannungsklemmschaltung konfiguriert ist, um die Einschaltschwellenspannung während des Einschaltens des Schaltkreisunterbrechers unter Verwendung von Strom zu erzeugen, der von der Eingangsenergiequelle (10, 10-1, 10-2) gezogen wird, wenn er an den Leitungseingangsanschluss des Schaltungsunterbrechers angelegt wird; und
wobei als Reaktion auf die Aktivierung des ersten Steuerschalters (360, 362, 460) der erste Steuerschalter (360, 362, 460) konfiguriert ist, um den Gate-Anschluss des Festkörperschalters (210, 212, 401, 402) mit dem Source-Anschluss des Festkörperschalters (210, 212, 401, 402) zu koppeln, um den Festkörperschalter (210, 212, 401, 402) in dem ausgeschalteten Zustand zu halten, bis die Einschaltschwellenspannung auf den konstanten Zielspannungspegel erzeugt ist.

3. Schaltungsunterbrecher (100, 200, 300, 400, 500, 600, 700) nach Anspruch 2, wobei die Spannungsklemmschaltung einen Kondensator (310, 312, 410) und eine Zenerdiode (320, 322, 420) umfasst, die parallel geschaltet sind.

4. Schaltungsunterbrecher (100, 200, 400, 500, 600, 700) nach Anspruch 2, wobei die Selbstvorspannungsschaltung ein Netzwerk (452, 454) aus Widerstand und Kondensator (RC) umfasst, das mit einem Steueranschluss des ersten Steuerschalters (460) gekoppelt ist, wobei das RC-Netzwerk (452, 454) während des Einschaltens des Schaltungsunterbrechers unter Verwendung von Strom geladen wird, der von der Eingangsenergiequelle (10, 10-1, 10-2) entnommen wird, wenn er an den Leitungseingangsanschluss des Schaltungsunterbrechers angelegt wird, wobei das RC-Netzwerk (452, 454) konfiguriert ist, um eine RC-Zeitkonstante aufzuweisen, die einer Zeitperiode entspricht, die nicht kleiner als eine Zeitperiode ist, die benötigt wird, um die Einschaltschwellenspannung auf den konstanten Zielspannungspegel während des Einschaltens des Schaltungsunterbrechers zu erzeugen.

5. Schaltungsunterbrecher (100, 200, 300, 600, 700) nach Anspruch 2, wobei die Selbstvorspannungsschaltung einen Operationsverstärker (350, 352) umfasst, der einen mit der Spannungsklemmschaltung verbundenen Eingang und einen mit einem Steueranschluss des ersten Steuerschalters (360, 362) verbundenen Ausgang aufweist, wobei der Operationsverstärker (350, 352) konfiguriert ist, um die Operation des ersten Steuerschalters (360, 362) zu steuern, indem der erste Steuerschalter (360, 362) während der Erzeugung der Einschaltschwellenspannung in einem eingeschalteten Zustand gehalten wird und der erste Steuerschalter (360, 362) in einen ausgeschalteten Zustand versetzt wird, nachdem die Einschaltschwellenspannung erzeugt wurde.

6. Schaltungsunterbrecher (100, 200, 300, 400, 500, 600, 700) nach Anspruch 2, wobei die Modussteuerschaltung (220, 222, 405, 710, 712) einen zweiten Steuerschalter (370, 372, 470) umfasst, der konfiguriert ist, um den Gate-Anschluss des Halbleiterschalters (210, 212, 401, 402) mit dem Source-Anschluss des Halbleiterschalters (210, 212, 401, 402) zu koppeln und die an den Steueranschluss des Festkörperschalters (210, 212, 401, 402) angelegte Einschaltschwellenspannung zu unterbrechen und dadurch den Festkörperschalter (210, 212, 401, 402) als Reaktion auf die Aktivierung des zweiten Steuerschalters (370, 372, 470) in einen ausgeschalteten Zustand zu versetzen.

7. Schaltkreisunterbrecher (100, 200, 300, 400, 500, 600, 700) nach Anspruch 6, ferner umfassend eine Sensorschaltung (230, 232, 380, 480), die konfiguriert ist, um ein Steuersignal zu erzeugen, um den zweiten Steuerschalter (370, 372, 470) als Reaktion darauf zu aktivieren, dass die Sensorschaltung (230, 232, 380, 480) einen Zustand erfasst, der es rechtfertigt, den Halbleiterschalter (210, 212, 401, 402) in den ausgeschalteten Zustand zu versetzen.

8. Schaltungsunterbrecher (100, 200, 300, 400, 500, 600, 700) nach Anspruch 7, wobei die Sensorschaltung (230, 232, 380, 480) einen Stromsensor umfasst, der konfiguriert ist, um einen Strom zu erfassen, der in dem elektrischen Pfad zwischen dem Leitungseingangsanschluss und dem Lastausgangsanschluss fließt, und einen Fehlerzustand zu erkennen, wobei der Fehlerzustand einen Kurzschlussfehlerzustand, einen Überstromfehlerzustand, einen Lichtbogenfehlerzustand oder einen Erdungsfehlerzustand umfasst.

9. Schaltungsunterbrecher (100, 200, 300, 400, 500, 600, 700) nach Anspruch 7, wobei die Sensorschaltung (230, 232, 380, 480) eine Umweltsensorschaltung (380, 480) umfasst, die konfiguriert ist, um einen gefährlichen Umweltzustand zu erfassen.

10. Schaltungsunterbrecher (100, 200, 300, 400, 500, 600, 700) nach Anspruch 9, wobei die Umweltsensorschaltung (380, 480) eines oder mehrere von i) einem chemikalienempfindlichen Detektor, der konfiguriert ist, um das Vorhandensein gefährlicher Chemikalien zu erfassen, ii) einem gasempfindlichen Detektor, der konfiguriert ist, um das Vorhandensein gefährlicher Gase zu erfassen, iii) einem Temperatursensor, der konfiguriert ist, um eine Temperatur zu erfassen, iv) einem piezoelektrischen Detektor, der konfiguriert ist, um Vibrationen zu erfassen; und v) einem Feuchtigkeitssensor, der konfiguriert ist, um eine feuchte Umgebung zu erfassen, umfasst.

11. Schaltungsunterbrecher (100, 200, 300, 400, 500, 600, 700) nach Anspruch 7, wobei der zweite Steuerschalter (370, 372, 470) einen Fototransistor umfasst und wobei die Sensorschaltung optisch mit dem Fototransistor gekoppelt ist, sodass der Fototransistor in Reaktion auf optische Steuersignale aktiviert wird.

12. Schaltungsunterbrecher (100, 200, 300, 400, 500, 600, 700) nach Anspruch 6, wobei der zweite Steuerschalter (370, 372, 470) einen Fototransistor umfasst und wobei der Fototransistor in Reaktion auf optische Steuersignale aktiviert wird.

13. Elektrischer Schaltungsunterbrecher, umfassend den Schaltungstrennschalter (100, 200, 300, 400, 500, 600, 700) nach Anspruch 1.

14. Elektrischer Schaltungsunterbrecher, umfassend den Schaltungsunterbrecher (100, 200, 300, 400, 500, 600, 700) nach Anspruch 1.

15. Elektrischer Lichtschalter, umfassend den Schaltungsunterbrecher (100, 200, 300, 400, 500, 600, 700) nach Anspruch 1.

## Revendications

1. Disjoncteur (100, 200, 300, 400, 500, 600, 700), comprenant :
un commutateur à semi-conducteurs (210, 212, 401, 402) connecté en série entre une borne d'entrée de ligne et une borne de sortie de charge du disjoncteur, et configuré pour être placé dans l'un parmi i) un état sous tension pour fournir une connexion électrique dans un chemin électrique entre la borne d'entrée de ligne et la borne de sortie de charge, et ii) un état hors tension ; et
un circuit de contrôle de mode (220, 222, 405, 710, 712) configuré pour implémenter un premier mode de contrôle et un second mode de contrôle afin de contrôler le fonctionnement du disjoncteur ;
dans lequel dans le premier mode de contrôle, le circuit de contrôle de mode (220, 222, 405, 710, 712) est configuré pour i) utiliser le courant tiré d'une source d'alimentation d'entrée (10, 10-1, 10-2) lorsqu'il est appliqué à la borne d'entrée de ligne du disjoncteur afin de générer une tension de seuil d'activation lors de la mise sous tension du disjoncteur, ii) coupler une borne de grille (G) du commutateur à semi-conducteurs (210, 212, 401, 402) à une borne de source (S) du commutateur à semi-conducteurs (210, 212, 401, 402) pendant la mise sous tension du disjoncteur afin de maintenir le commutateur à semi-conducteurs (210, 212, 401, 402) à l'état hors tension jusqu'à ce que la tension de seuil d'activation soit générée à un niveau de tension cible constant, et iii) découpler la borne de grille (G) du commutateur à semi-conducteurs (210, 212, 401, 402) de la borne de source (S) du commutateur à semi-conducteurs (210, 212, 401, 402) afin d'appliquer ainsi la tension de seuil d'activation au niveau de tension cible constant à la borne de grille (G) du commutateur à semi-conducteurs (210, 212, 401, 402) pour placer le commutateur à semi-conducteurs (210, 212, 401, 402) à l'état sous tension ; et
dans lequel dans le second mode de contrôle, le circuit de contrôle de mode (220, 222, 405, 710, 712) est configuré pour coupler la borne de grille (G) du commutateur à semi-conducteurs (210, 212, 401, 402) à la borne de source (S) du commutateur à semi-conducteurs (210, 212, 401, 402) afin d'interrompre la tension de seuil d'activation appliquée à la borne de grille (G) du commutateur à semi-conducteurs (210, 212, 401, 402) et de placer ainsi le commutateur à semi-conducteurs (210, 212, 401, 402) à l'état hors tension.

2. Disjoncteur (100, 200, 300, 400, 500, 600, 700) selon la revendication 1, dans lequel le circuit de contrôle de mode (220, 222, 405, 710, 712) comprend :
un circuit à polarisation automatique comprenant un circuit limiteur de tension et un premier commutateur de contrôle (360, 362, 460) ;
dans lequel le circuit limiteur de tension est configuré pour générer la tension de seuil d'activation lors de la mise sous tension du disjoncteur à l'aide du courant tiré de la source d'alimentation d'entrée (10, 10-1, 10-2) lorsqu'il est appliqué à la borne d'entrée de ligne du disjoncteur ; et
dans lequel en réponse à l'activation du premier commutateur de contrôle (360, 362, 460), le premier commutateur de contrôle (360, 362, 460) est configuré pour coupler la borne de grille du commutateur à semi-conducteurs (210, 212, 401, 402) à la borne de source du commutateur à semi-conducteurs (210, 212, 401, 402) afin de maintenir le commutateur à semi-conducteurs (210, 212, 401, 402) à l'état hors tension jusqu'à ce que la tension de seuil d'activation soit générée au niveau de tension cible constant.

3. Disjoncteur (100, 200, 300, 400, 500, 600, 700) selon la revendication 2, dans lequel le circuit limiteur de tension comprend un condensateur (310, 312, 410) et une diode Zener (320, 322, 420) connectés en parallèle.

4. Disjoncteur (100, 200, 400, 500, 600, 700) selon la revendication 2, dans lequel le circuit à polarisation automatique comprend un réseau résistance-condensateur (RC) (452, 454) couplé à une borne de contrôle du premier commutateur de contrôle (460), dans lequel le réseau RC (452, 454) est chargé lors de la mise sous tension du disjoncteur à l'aide du courant tiré de la source d'alimentation d'entrée (10, 10-1, 10-2) lorsqu'il est appliqué à la borne d'entrée de ligne du disjoncteur, dans lequel le réseau RC (452, 454) est configuré pour avoir une constante de temps RC qui correspond à une durée qui n'est pas inférieure à une durée nécessaire pour générer la tension de seuil d'activation au niveau de tension cible constant lors de la mise sous tension du disjoncteur.

5. Disjoncteur (100, 200, 300, 600, 700) selon la revendication 2, dans lequel le circuit à polarisation automatique comprend un amplificateur opérationnel (350, 352) ayant une entrée connectée au circuit limiteur de tension et une sortie connectée à une borne de contrôle du premier commutateur de contrôle (360, 362), dans lequel l'amplificateur opérationnel (350, 352) est configuré pour contrôler le fonctionnement du premier commutateur de contrôle (360, 362) en maintenant le premier commutateur de contrôle (360, 362) dans un état sous tension lors de la génération de la tension de seuil d'activation, et en plaçant le premier commutateur de contrôle (360, 362) dans un état hors tension après que la tension de seuil d'activation a été générée.

6. Disjoncteur (100, 200, 300, 400, 500, 600, 700) selon la revendication 2, dans lequel le circuit de contrôle de mode (220, 222, 405, 710, 712) comprend un second commutateur de contrôle (370, 372, 470) qui est configuré pour coupler la borne de grille du commutateur à semi-conducteurs (210, 212, 401, 402) à la borne de source du commutateur à semi-conducteurs (210, 212, 401, 402) et à interrompre la tension de seuil d'activation appliquée à la borne de contrôle du commutateur à semi-conducteurs (210, 212, 401, 402), et à placer ainsi le commutateur à semi-conducteurs (210, 212, 401, 402) dans un état hors tension, en réponse à l'activation du second commutateur de contrôle (370, 372, 470).

7. Disjoncteur (100, 200, 300, 400, 500, 600, 700) selon la revendication 6, comprenant en outre un circuit de capteur (230, 232, 380, 480) qui est configuré pour générer un signal de contrôle afin d'activer le second commutateur de contrôle (370, 372, 470) en réponse au circuit de capteur (230, 232, 380, 480) détectant une condition qui justifie le placement du commutateur à semi-conducteurs (210, 212, 401, 402) dans l'état hors tension.

8. Disjoncteur (100, 200, 300, 400, 500, 600, 700) selon la revendication 7, dans lequel le circuit de capteur (230, 232, 380, 480) comprend un capteur de courant qui est configuré pour détecter un courant circulant dans le chemin électrique entre la borne d'entrée de ligne et la borne de sortie de charge, et pour détecter une condition de défaut, dans lequel la condition de défaut comprend l'une parmi une condition de défaut de court-circuit, une condition de défaut de surintensité, une condition de défaut d'arc et une condition de défaut à la terre.

9. Disjoncteur (100, 200, 300, 400, 500, 600, 700) selon la revendication 7, dans lequel le circuit de capteur (230, 232, 380, 480) comprend un circuit de capteur environnemental (380, 480) qui est configuré pour détecter une condition environnementale dangereuse.

10. Disjoncteur (100, 200, 300, 400, 500, 600, 700) selon la revendication 9, dans lequel le circuit de capteur environnemental (380, 480) comprend un ou plusieurs parmi i) un détecteur sensible aux produits chimiques qui est configuré pour détecter une présence de produits chimiques dangereux, ii) un détecteur sensible aux gaz qui est configuré pour détecter une présence de gaz dangereux, iii) un capteur de température qui est configuré pour détecter une température, iv) un détecteur piézoélectrique qui est configuré pour détecter des vibrations ; et v) un capteur d'humidité qui est configuré pour détecter un environnement humide.

11. Disjoncteur (100, 200, 300, 400, 500, 600, 700) selon la revendication 7, dans lequel le second commutateur de contrôle (370, 372, 470) comprend un phototransistor et dans lequel le circuit de capteur est couplé optiquement au phototransistor de telle sorte que le phototransistor est activé en réponse à des signaux de contrôle optiques.

12. Disjoncteur (100, 200, 300, 400, 500, 600, 700) selon la revendication 6, dans lequel le second commutateur de contrôle (370, 372, 470) comprend un phototransistor et dans lequel le phototransistor est activé en réponse à des signaux de contrôle optiques.

13. Disjoncteur électrique comprenant le disjoncteur (100, 200, 300, 400, 500, 600, 700) selon la revendication 1.

14. Dispositif de prise électrique comprenant le disjoncteur (100, 200, 300, 400, 500, 600, 700) selon la revendication 1.

15. Commutateur d'éclairage électrique comprenant le disjoncteur (100, 200, 300, 400, 500, 600, 700) selon la revendication 1.
